(19) **Europäisches Patentamt / European Patent Office / Office européen des brevets**

(11) **EP 1 746 432 B1**

(12) **EUROPÄISCHE PATENTSCHRIFT**

(45) Veröffentlichungstag und Bekanntmachung des Hinweises auf die Patenterteilung:
**12.03.2008   Patentblatt 2008/11**

(51) Int Cl.:
***G01R 33/422*** *(2006.01)*

(21) Anmeldenummer: **06014890.5**

(22) Anmeldetag: **18.07.2006**

(54) **HF-Schirm mit reduzierter Kopplung zum HF-Resonatorsystem**

Rf shield with reduced coupling to the rf resonator system

Ecran HF avec couplage réduit pour un système de résonance HF

(84) Benannte Vertragsstaaten:
**CH FR GB LI**

(30) Priorität: **21.07.2005   DE 102005033989**

(43) Veröffentlichungstag der Anmeldung:
**24.01.2007   Patentblatt 2007/04**

(73) Patentinhaber: **Bruker BioSpin AG**
**8117 Fällanden (CH)**

(72) Erfinder: **Freytag, Nicolas**
**8122 Binz (CH)**

(74) Vertreter: **Kohler Schmid Möbus**
**Patentanwälte**
**Ruppmannstrasse 27**
**70565 Stuttgart (DE)**

(56) Entgegenhaltungen:

| | |
|---|---|
| WO-A-01/78089 | WO-A-03/008988 |
| DE-A1- 19 843 905 | GB-A- 2 338 788 |
| JP-A- 5 082 333 | US-A- 4 642 569 |
| US-A- 5 367 261 | US-B1- 6 420 871 |

**Beschreibung**

Die Erfindung betrifft eine Kemspinresonanzapparatur zur Erzeugung eines homogenen statischen Magnetfelds in einer z-Richtung, mit mindestens einem Spulen-/Resonatorsystem, das dem Senden und/oder Empfangen von Hochfrequenz(HF)-Signalen auf mindestens einer Messfrequenz dient, einem Gradientensystem, das zur Erzeugung von gepulsten Feldgradienten in mindestens einer Raumrichtung dient, und einer Abschirmanordnung, die radial bezüglich der z-Richtung zwischen dem mindestens einen Spulen-/Resonatorsystem und dem Gradientensystem positioniert ist, wobei die Abschirmanordnung zylindermantelförmig ist und mindestens eine elektrisch leitende Schicht mit mindestens einem Schlitz umfasst, wobei die elektrisch leitende Schicht zur z-Richtung axialsymmetrisch um den Mittelpunkt der Abschirmanordnung angeordnet ist, und der mindestens eine Schlitz die mindestens eine elektrisch leitende Schicht in einer Richtung, die eine z-Komponente ungleich 0 aufweist, vollständig durchtrennt und in Teilstücke unterteilt, wobei die Abschirmanordnung in einem axialen Abschnitt $z1 < z < z2$ , mit $z2 - z1 > L$, wobei L = Fensterlänge des Spulen-/Resonatorsystems, in der mindestens 90% der magnetischen Feldenergie des Spulen-/Resonatorsystems enthalten ist, mindestens ein Paar von zylindermantelförmigen Bereichen um die z-Richtung aufweist, wobei die zwei Bereiche (6) eines jeden Paares jeweils durch zwei um die z-Richtung umlaufende, in sich geschlossene Grenzlinien definiert sind, und wobei die zwei Grenzlinien jedes Bereichs einen axialen Abstand $a \leq \dfrac{z2 - z1}{2}$ voneinander aufweisen und auf Ebenen parallel zur xy-Ebene, d.h. senkrecht zur z-Richtung, liegen.

Eine derartige Kernspinresonanzapparatur ist beispielsweise aus [13] bekannt.

Eine Gradientenabschirmanordnung soll für die hochfrequenten Felder der Spulen-/Resonatorsystems undurchsichtig sein, jedoch das Schalten der (DC-) Gradientenpulse nicht behindern. Letztere liegen in einem Frequenzbereich in der Größenordnung von ≤ 10 kHz.

Um dies zu erreichen werden bei den bekannten Abschirmanordnungen die Strompfade, welche die beim Schalten der Gradienten induzierten Wirbelströme gehen "möchten", durch Schlitzen der Abschirmanordnung unterbrochen. Zugleich müssen jedoch die Spiegelströme, die das Abschirmen der HF-Felder ermöglichen, trotzdem fließen können. Dies wird durch Überbrücken der Schlitze mit kapazitiven Elementen erreicht, die für die HF-Ströme durchlässig erscheinen, jedoch für die quasi-DC-Ströme beim Schalten der Gradienten sperren.

Die gängigen zwei Lösungsansätze für die Anordnung der Schlitze sind Folgende:

Bei den aus [4], [5], [7], [10] bekannten Vorrichtungen wird eine gut elektrisch leitende, metallische Schicht mittels ringförmiger Leiterelemente so strukturiert, dass die Spiegelströme des HF-Stromes "imitiert" werden. Dabei wird zusätzlich jeder dieser ringförmiges Leiterelement nochmals zerschnitten, so dass die Wirbelströme der Gradientenströme nicht fließen können. Um den HF-Pfad zu ermöglichen wird eine zweite Schicht mittels eines Dielektrikums getrennt aufgebracht, so dass eine kapazitive Verbindung für die HF-Abschirmströme entsteht. Alternativ dazu wird ein diskreter Kondensator über die Schlitze hinweg angebracht, der für die HF-Ströme den Pfad schließt.

Ein anderer Lösungsansatz sieht eine n-fache Unterteilung in axialer Richtung vor, wobei durch Überlappungen und/oder Einbau diskreter kapazitiver Elemente für ausreichend kapazitive Kopplungen zwischen den streifenförmigen Teilstücken gesorgt wird [1]-[3], [6], [8], [9]. Zusätzlich können noch in radialer Richtung Schlitze angebracht werden. In manchen Ausführungsformen durchschneiden nicht alle Schlitze die leitende Schicht in z-Richtung vollständig.

Die Positionierung der Schlitze ist in der Regel insbesondere im Bereich des Spulen-/Resonatorsystem von den HF-Bedingungen getrieben, andererseits können zusätzliche Schlitze an bestimmten Orten angebracht werden, um die verbleibenden Wirbelströme weiter zu dämpfen.

Es gibt zwei vereinfachte Modelle, wie man sich den Effekt der Schlitze vorstellen kann:

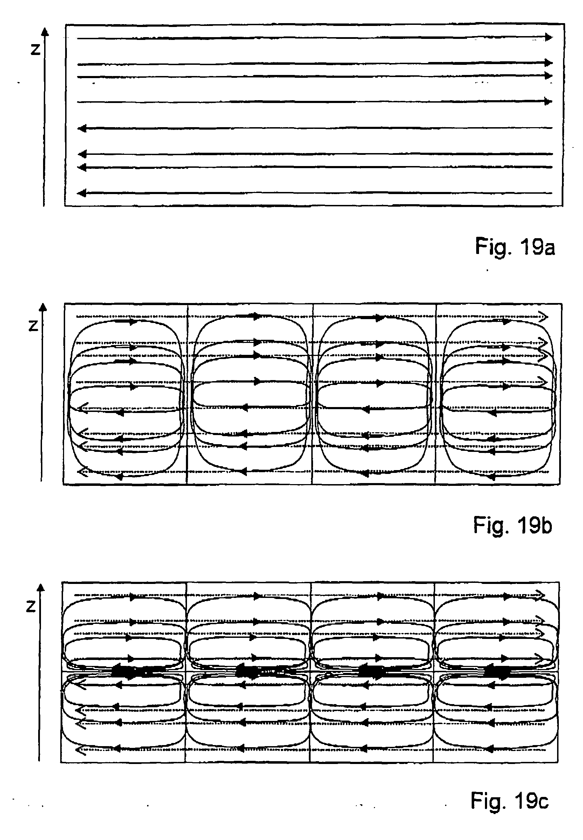

Beim ersten Modell geht man davon aus, dass die Wirbelströme trotz Schlitz versuchen genauso weiterzufließen wie bei einer Abschirmanordnung ohne Schlitze (**Fig. 19a**). Aus **Fig. 19b** geht hervor, dass in der dargestellten geschlitzten Abschirmanordnung (hier abgewickelt dargestellt) lediglich die Ströme entlang der senkrechten Schlitze zusätzlich fließen, was dazu führt, dass der Widerstand für die Abschirmströme steigt und somit die Abklingzeiten sinken. Je mehr Schlitze eingebracht werden, desto schneller klingen die Wirbelströme ab. Aus **Fig. 19c** wird auch klar, dass insbesondere für einen z-Gradienten ein radialer Schlitz in der Mitte hilfreich ist, da er die Bereiche mit linksdrehenden von denen mit rechtsdrehenden Strömen separiert.

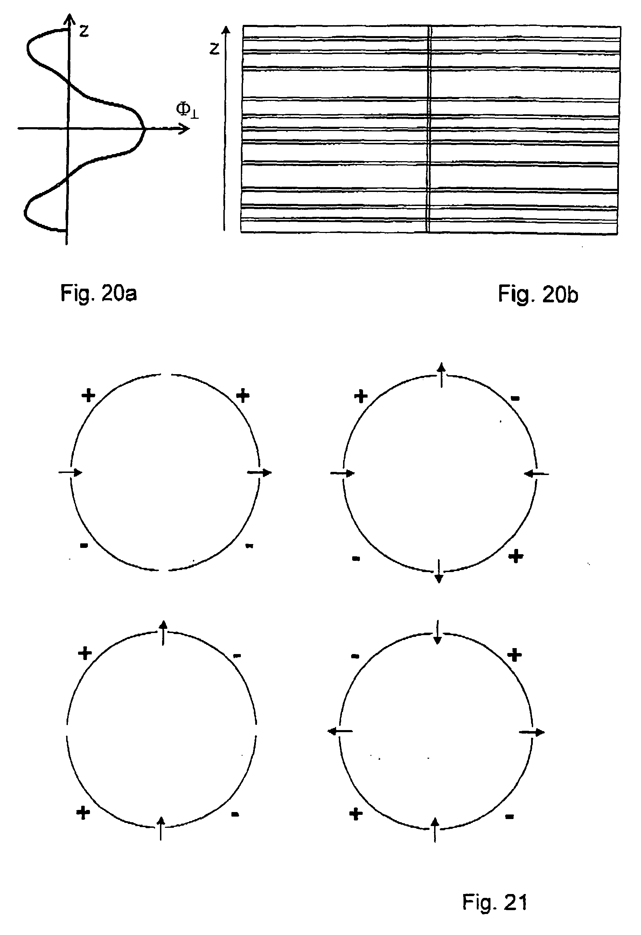

Ein zweites Modell geht davon aus, dass der Fluss ungestört bleibt und sich die Ströme in den einzelnen Abschnitten gemäß den sie durchdringenden Flüssen verteilen. Hierbei geht man davon aus, dass ein Strom endgültig unterbrochen ist, wenn er durch einen Schlitz unterbunden wurde (d.h. man benötigt lediglich einen einzigen axialen Schlitz und schlitzt den Rest radial. **Fig. 20b** zeigt dies für einen z-Gradienten.

Im Gegensatz zum ersten Modell (Fig. 19b), bei dem im Bereich größter Ströme (und zugleich geringstem senkrechten Fluss) am meisten geschlitzt werden muss, muss beim zweiten Modell (Fig. 20b) im End-Bereich (außerhalb der Umkehrpunkte des Gradienten) und im Zentrum am feinsten unterteilt werden, da hier der größte Fluss "zu den Schlitzen heraus diffundieren" muss. **Fig. 20a** zeigt den senkrechten magnetischen Fluss in Abhängigkeit von der axialen Koordinate z.

In Wirklichkeit beschreiben beide Modelle den realen Sachverhalt nur unzureichend. Sie stellen lediglich die beiden Grenzwerte der Betrachtungen dar (ungestörter Strom im ersten Fall und ungestörter Fluss im zweiten Fall). Um genauere Angaben über die ideale Position der Schlitze zu bekommen, ist eine Simulationsrechnung notwendig, die das zeitliche Abklingen der Gradientenfelder nach dem Abschalten für einen konkreten Fall exakt aufzeigen kann. Auf iterative Art und Weise können dann die Schlitze positioniert werden. Problematisch ist hier allerdings, dass die Kopplungen mit den Resonatorsystemen, eventuell vorhandenen Shim-Spulen, Rohren, Elementen des Resonatorsystems etc. mitberücksichtigt werden müssen.

Die Abschirmwirkung der Abschirmanordnung bezüglich der HF-Felder beruht bei beiden oben aufgezeigten Ausführungsformen gemäß dem Stand der Technik darauf, dass die erste Eigenresonanz der HF-Abschirmanordnung unterhalb der Resonanzfrequenz der NMR-Spule liegt. Wäre dies nicht der Fall, so würde keine ausreichende kapazitive Kopplung bestehen, um die HF-Felder abzuschirmen.

Die Dicke der elektrisch leitenden Schicht wird jeweils so gewählt, dass die HF-Verluste minimiert werden und zugleich der DC-Widerstand möglichst hoch liegt. Die gängige Lösung ist es, Schichtdicken von etwa 3 Eindringtiefen (bei NMR-Frequenz) zu verwenden.

Insbesondere bei den aus [1]-[3], [6], [8], [9] bekannten Abschirmanordnungen, die prinzipiell eine radiale Anordnung von Metall-Streifen darstellen, entsteht eine Vielzahl von Eigenresonanzen auf der Abschirmanordnung, die zu Problemen führen können. Prinzipiell weist eine solche Anordnung ebenso viele Moden wie Streifen auf. **Fig.21** zeigt dies beispielhaft für eine Anordnung mit vier Streifen. Darüber hinaus ergibt sich zusätzlich ein Spektrum von Oberschwingungen, wenn die Wellenlänge klein gegenüber den Dimensionen wird. Je mehr Elemente in einer solchen Abschirmanordnung verbaut sind, desto mehr Resonanzen weist sie auf. Um eine möglichst hohe Transparenz für die Gradientenfelder zu realisieren, ist jedoch eine sehr feine Unterteilung notwendig (z.B. n = 8, 16, 32). In diesem Fall wird das Spektrum so eng, dass nur noch sehr wenige Frequenzbänder übrig bleiben, in denen die Messfrequenzen zu liegen kommen können.

Derartige Innenabschirmungen werden in der Regel in der MRI eingesetzt, wo eine, maximal zwei Messfrequenzen existieren und beide Frequenzen in der Regel zum Teil deutlich unter 200 MHz liegen. In diesem Fall kann durch Wahl der Kapazitäten zwischen den Streifen die Abschirmanordnung so gestaltet werden, dass keine der maximal zwei Messfrequenzen mit den Eigenmoden der Abschirmanordnung kollidiert. Wäre dies der Fall, so würde erstens die Abschirmwirkung deutlich reduziert und zweitens in der Regel die Güte und/oder Effizienz des Resonatorsystems ruiniert.

In einem NMR-System ist die Situation jedoch anders. In der Regel existieren mindestens vier Messfrequenzen, möglicherweise sogar ein sehr breites Band von Frequenzen, die alle abstimmbar sein müssen. Insbesondere bei Abschirmanordnungen, die aus mehreren Elementen bestehen ist es daher quasi unmöglich, diese so auszuführen, dass keine der Messfrequenzen in die Nähe einer Eigenresonanz der Abschirmanordnung zu liegen kommt und zugleich ausreichende Abschirmwirkung für alle Moden zu garantieren.

Aus den Druckschriften [11] und [12] ist ein Spulentyp bekannt, der durch eine geometrische Anordnung der Leiter, die eine Rotation um $n * 2\pi$ über das Fenster einer weiteren Spule aufweist, die Kopplung zwischen den beiden Spulen geometrisch aufhebt. Hierbei ist das Integral des magnetischen Flusses der einen Spule, der mit der anderen Spule wechselwirkt null. [13] offenbart eine kapazitive Abschirmung für eine MRI-Apparatur mit einer dielektrischen Schicht gemäß dem Oberbegriff der Ansprüche 1 und 8, die beidseitig mit jeweils einer elektrisch leitenden Schicht umgeben ist. Die elektrisch leitende Schicht umfasst elektrisch leitende Bereiche, die voneinander durch nicht leitende Bereiche getrennt sind, die als Schlitze ausgeführt sein können. Eine solche Abschirmanordnung koppelt jedoch stark mit einem Resonatorsystem einer Kernspinresonanzapparatur.

Es ist Aufgabe der Erfindung, eine Kernspinresonanzapparatur vorzuschlagen, deren Abschirmanordnung so gestaltet ist, dass nur wenig oder keine Energie aus dem Resonator/Spulensystem in die Abschirmanordnung gekoppelt wird.

Diese Aufgabe wird erfindungsgemäß dadurch gelöst, dass die beiden Bereiche des mindestens einen Paares von zylindermantelförmigen Bereichen der Abschirmanordnung aufgrund der Geometrie der Abschirmanordnung so positioniert sind, dass sie für mindestens einen Teil der Eigenmoden der Abschirmanordnung entgegengesetzte induktive Kopplungen mit dem mindestens einen Spulen-/Resonatorsystem aufweisen. Dies wird erfindungsgemäß alternativ durch die Merkmale des kennzeichnenden Teils des Anspruchs 1 oder des Anspruchs 8 erreicht. Durch eine solche geometrische Anordnung der Elemente der Abschirmanordnung wird eine vernachlässigbare induktive Kopplung zwischen dem Resonatorsystem und einer gewissen Anzahl von Eigenmoden der Abschirmanordnung erreicht. Unter diesen Voraussetzungen kann das Resonatorsystem auch dann mit geringen zusätzlichen Verlusten betrieben werden, wenn eine Eigenresonanz der Abschirmanordnung in die Nähe oder sogar exakt auf einer Messfrequenz zu liegen kommt. Die "Entkopplung" zwischen den beiden Systemen wird bei der erfindungsgemäßen Apparatur rein geometrisch erreicht, indem entlang der z-Richtung jeweils paarweise Bereiche mit entgegengesetzter Kopplung (und nach Möglichkeit gleicher Kopplungsstärke) auftreten, so dass sich die Kopplung von Bereichen jeweils paarweise zumindest weitestgehend aufhebt.

Erfindungsgemäß ist der mindestens eine Schlitz so angeordnet, dass jedes der Teilstücke innerhalb der Fensterlänge des mindestens einen Spulen-/ Resonatorsystems mindestens einmal vollständig um die z-Richtung rotiert. Der Schlitz kann kapazitiv geschlossen sein, so dass die tiefste Eigenresonanz der Abschirmanordnung unterhalb der Eigenresonanz der NMR-Kerne liegt.

Bei einer speziellen Ausführungsform der erfindungsgemäßen Kernspinresonanzapparatur verläuft bei mindestens einem Schlitz der elektrisch leitenden Schicht der Abschirmanordnung die Steigung über den gesamten Abschnitt $z1 < z < z2$ der Abschirmanordnung gleichmäßig.

Besonders vorteilhaft ist es, wenn mindestens ein Schlitz der elektrisch leitenden Schicht der Abschirmanordnung ein ganzzahliges Vielfaches von Umdrehungen um die z-Richtung entlang der Fensterlänge einer oder aller HF-Spulen-/Resonatorsysteme aufweist. In diesem Fall ist die Kopplung der HF-Spulen-/Resonatorsysteme vernachlässigbar.

Eine besonders bevorzugte Ausführungsform der Erfindung sieht vor, dass zusätzlich zu dem mindestens einen Schlitz, der die elektrisch leitende Schicht der Abschirmanordnung vollständig durchtrennt, mindestens ein weiterer Schlitz vorgesehen ist, der an einer Endkante der Abschirmanordnung beginnend die elektrisch leitende Schicht nicht vollständig durchtrennt. Dies kann beispielsweise dann hilfreich sein, wenn die Amplitude der Wirbelströme beim Schalten des Gradienten in bestimmten Bereichen höher ist als in anderen.

Da dies hauptsächlich im Bereich außerhalb der Fensterlänge auftritt, verläuft bei einer Weiterbildung dieser Ausführungsform mindestens einer der weiteren Schlitze ausschließlich außerhalb der Fensterlänge des mindestens einen Spulen-/ Resonatorsystems.

Eine alternative Ausführungsform sieht vor, dass die weiteren Schlitze innerhalb der Fenstedänge des mindestens einen Spulen-/Resonatorsystems mindestens einmal vollständig um die z-Richtung rotiert sind.

Vorzugsweise sind dabei die weiteren Schlitze innerhalb der Fensterlänge des mindestens einen HF-Spulen/Resonatorsystems um ein ganzzahliges Vielfaches einer vollen Umdrehung um die z-Richtung verdreht.

Bei einer vorteilhaften Ausführungsform der erfindungsgemäß Apparatur weisen die Schlitze außerhalb des Fensterlänge des mindestens einen HF-Spulen-/Resonatorsystems eine niedrigere Steigung als innerhalb der Fensterlänge auf. Auf diese Weise können stärkere Felder außerhalb der Fensterlänge kompensiert werden.

Alternativ dazu ist auch eine Ausführungsform denkbar, bei der die Schlitze außerhalb der des Fensterlänge des mindestens einen HF-Spulen-/Resonatorsystems eine höhere Steigung als innerhalb der Fensterlänge aufweisen oder axial verlaufen. Somit können schwächere Felder außerhalb der Fensterlänge kompensiert werden.

Prinzipiell ist es vorteilhaft, wenn die Steigungen der Schlitze so angepasst sind, dass eine möglichst geringe Kopplung zwischen der Abschirmanordnung und dem mindestens einen Spulen-/Resonatorsystems erreicht wird.

Eine weitere Ausführungsform einer Kemspinresonanzapparatur, die auch in den Rahmen der Erfindung fällt, ist dadurch gekennzeichnet dass die beiden zylinderförmigen Bereiche eines eingangs beschriebenen Paares aufgrund der Geometrie der Abschirmanordnung so positioniert sind, dass sie für mindestens einen Teil der Eigenmoden der Abschirmanordnung entgegengesetzte induktive Kopplungen mit dem mindestens einem Spulen-/Resonatorsystem aufweisen, wobei der mindestens eine Schlitz der elektrisch leitenden Schicht der Abschirmanordnung durchgehend radial (parallel zur xy-Ebene) verläuft, wobei die Anordnung des mindestens einen Schlitzes, der parallel zur xy-Ebene verläuft, spiegelsymmetrisch in Bezug auf die xy-Ebene ist, und zumindest in einem zentralen Bereich der Fensterlänge zusätzlich mindestens ein Paar von axialen Schlitzen vorgesehen sind, welche parallel zur z-Richtung orientiert sind und jeweils zwei benachbarte parallel zur xy-Ebene verlaufende Schlitze oder einen parallel zur xy-Ebene verlaufenden Schlitz und eine Endkante der elektrisch leitenden Schicht der Abschirmanordnung verbinden, wobei die gesamte Anordnung der Schlitze eine Punktsymmetrie bezüglich des Mittelpunkts der Abschirmanordnung, aber keine Spiegelsymmetrie zur xy-Ebene aufweist, welche durch das Zentrum des Spulen-/Resonatorsystems verläuft. Die Abschirmanordnung ist gegenüber dem Spulen-/Resonatorsystem so positioniert, dass die Kopplung zwischen dem mindestens einen Spulen-/Resonatorsystem und der Abschirmanordnung minimiert wird.

Aufgrund der Punktsymmetrie der Abschirmanordnung weisen auch hier jeweils zwei Bereiche entgegengesetzte Kopplungen auf.

Dabei ist es möglich, dass ein Bereich der Abschirmanordnung in der Mitte der Fensterlänge existiert, der keinen Schlitz aufweist, da hier beim Abklingen des Gradienten nur geringe Wirbelströme generiert werden.

Alle Bereiche der Abschirmanordnung weisen vorzugsweise in z-Richtung jeweils einen axialen Schlitz auf. Die axialen Schlitze der einzelnen Bereiche sind dabei punktsymmetrisch angeordnet.

Bei einer speziellen Ausführungsform der Erfindung sind die Abstände benachbarter radialer Schlitze jeweils identisch. Diese Ausführungsform ist besonders einfach herzustellen, da beispielsweise keine Rechnung der Recovery-Ströme der Gradienten erfolgen muss.

Eine alternative Ausführungsform sieht dagegen vor, dass die Abstände benachbarter radialer Schlitze im Bereich der Mitte der Fensterlänge geringer sind als außerhalb der Fensterlänge. Dies ist insbesondere für Anordnungen vorteilhaft, bei denen in der Mitte der Fensterlänge besonders hohe Gradienten-Wirbelströme auftreten

Alternativ dazu ist es auch möglich, dass die Abstände benachbarter radialer Schlitze im Bereich der Mitte der Fensterlänge größer sind als außerhalb der Fensterlänge L. Hierdurch ergeben sich geringere HF-Verluste, da die HF-Spiegelströme auf ungeschlitzten Pfaden beziehungsweise über wenige Kapazitäten fließen müssen.

Für alle Ausführungsformen der erfindungsgemäßen Kernspinresonanzapparatur ist es vorteilhaft, wenn die Abschirmanordnung genau eine elektrisch leitende Schicht und kapazitive Elemente aufweist, die über den mindestens einen Schlitz angebracht sind, so dass HF-Ströme im Bereich der Messfrequenz weitestgehend ungehindert fließen können.

Darüber hinaus ist es denkbar, dass die Abschirmanordnung zwei elektrisch leitende Schichten umfasst, zwischen denen eine dielektrische, nicht leitende Schicht angeordnet ist, wobei die Schlitze in den beiden elektrisch leitenden Schichten nicht deckungsgleich verlaufen. Auf zusätzliche kapazitive Elemente kann dann verzichtet werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1a     ein Frequenzspektrum der Resonanzfrequenzen der wichtigsten NMR-Kerne;

Fig. 1b     ein Frequenzspektrum der Messfrequenzen eines typischen NMR-Probenkopfs ($^{15}$N, $^{2}$H, $^{13}$C, $^{1}$H) bei B=18,79T;

Fig. 1c     ein Frequenzspektrum desselben Probenkopfes mit Resonanzfrequenzen für $^{15}$N, $^{2}$H, $^{13}$C und $^{1}$H bei B=11.74, 14.09, 15.44, 18.79T;

Fig. 2     eine Abwicklungsdarstellung einer geschlitzten elektrisch leitenden Schicht einer erfindungsgemäßen Abschirmanordnung;

Fig. 3a     Aufsichtsdarstellungen von erfindungsgemäßen elektrisch leitenden Schichten mit einem spiralförmigen Schlitz der Periodizität $2\pi$, $4\pi$, $8\pi$ ;

Fig. 3b     Aufsichtsdarstellungen von erfindungsgemäßen elektrisch leitenden Schichten mit zwei spiralförmigen Schlitzen der Periodizität $2\pi$, $4\pi$, $6\pi$;

Fig. 3c     Aufsichtsdarstellungen von erfindungsgemäßen elektrisch leitenden Schichten mit vier beziehungsweise acht spiralförmigen Schlitzen der Periodizität $2\pi$, $4\pi$;

Fig. 4     eine Aufsichtsdarstellung einer elektrisch leitenden Schicht einer erfindungsgemäßen Abschirmanordnung mit einem spiralförmigen Schlitz für eine Kernspinresonanzapparatur mit zwei Spulen-/Resonatorsystemen;

Fig. 5     eine Aufsichtsdarstellung einer elektrisch leitenden Schicht einer erfindungsgemäßen Abschirmanordnung mit einem spiralförmigen Schlitz mit variabler Steigung für eine Kernspinresonanzapparatur mit zwei Spulen-/Resonatorsystemen;

Fig. 6a     eine Aufsichtsdarstellung einer elektrisch leitenden Schicht einer erfindungsgemäßen Abschirmanordnung mit axial geschlitzten Außenbereichen;

Fig. 6b     eine Abwicklungsdarstellung eines Teilstücks der elektrisch leitenden Schicht der Abschirmanordnung aus Fig. 6a;

Fig. 7a     eine Aufsichtsdarstellung einer elektrisch leitenden Schicht einer erfindungsgemäßen Abschirmanordnung mit weiteren axialen Schlitzen im Außenbereich;

Fig. 7b     eine Abwicklungsdarstellung eines Teilstücks der elektrisch leitenden Schicht der Abschirmanordnung aus Fig. 7a;

Fig. 8a     eine Aufsichtsdarstellung einer elektrisch leitenden Schicht einer erfindungsgemäßen Abschirmanordnung mit weiteren spiralförmigen Schlitzen im Außenbereich;

Fig. 8b     eine Abwicklungsdarstellung eines Teilstücks der elektrisch leitenden Schicht der Abschirmanordnung aus Fig. 8a;

Fig. 9     eine Aufsichtsdarstellung einer elektrisch leitenden Schicht einer erfindungsgemäßen Abschirmanordnung mit weiteren spiralförmigen Schlitzen innerhalb der Fensterlänge des Spulen-/Resonatorsystems;

Fig. 10a     ein rechteckiges Feldprofil eines idealen Spulen-/Resonatorsystems mit schematischer Darstellung von Bereichen einer erfindungsgemäßen Abschirmanordnung mit entgegengesetzten Kopplungen;

Fig. 10b     eine graphische Auftragung des Verlaufs eines Schlitzes einer elektrisch leitenden Schicht einer erfindungsgemäßen Abschirmanordnung für das rechteckiges Feldprofil gemäß Fig. 10a;

Fig. 11a    ein realistisches Feldprofil;

Fig. 11b    eine graphische Auftragung des Verlaufs eines Schlitzes einer elektrisch leitenden Schicht einer erfindungsgemäßen Abschirmanordnung für das Feldprofil aus Fig. 11a;

Fig. 12a    ein weiteres realistisches Feldprofil;

Fig. 12b    eine graphische Auftragung des Verlaufs eines Schlitzes einer elektrisch leitenden Schicht einer erfindungsgemäßen Abschirmanordnung für das Feldprofil aus Fig. 12a;

Fig. 13    eine Aufsichts- und Abwicklungsdarstellung einer elektrisch leitenden Schicht einer erfindungsgemäßen Abschirmanordnung mit punktsymmetrischer Schlitzung;

Fig. 14    einen spiegelsymmetrischen Feldverlauf des Spulen/Resonatorsystems, sowie eine Aufsichtsdarstellung einer elektrisch leitenden Schicht einer Abschirmanordnung mit punktsymmetrischer Schlitzung;

Fig. 15a    eine Aufsichts- und Abwicklungsdarstellung einer elektrisch leitenden Schicht einer Abschirmanordnung mit punktsymmetrischer Schlitzung mit mehreren radialen Schlitzen;

Fig. 15b,c    Aufsichts- und Abwicklungsdarstellungen von elektrisch leitenden Schichten mit punktsymmetrischer Schlitzung und einer Vielzahl von axialen und radialen Schlitzen;

Fig. 16    eine Aufsichts- und Abwicklungsdarstellung einer elektrisch leitenden Schicht einer Abschirmanordnung mit punktsymmetrischer Schlitzung und ungeschlitztem Mittelbereich;

Fig. 17a    eine graphische Auftragung des senkrechten magnetischen Flusses in Abhängigkeit von z;

Fig. 17b    eine Aufsichts- und Abwicklungsdarstellung einer zu dem in Fig. 17a dargestellten Flussverlauf gehörigen elektrisch leitenden Schicht einer Abschirmanordnung mit punktsymmetrischer, unregelmäßiger radialer Schlitzung;

Fig. 18a    eine schematische Aufsichts- und Querschnittsdarstellung zweier kapazitiv verbundener elektrisch leitenden Schichten;

Fig. 18b    eine Aufsichts- und Querschnittsdarstellung zweier mittels einer weiteren elektrisch leitenden Schicht und eines Dielektrikums kapazitiv verbundener elektrisch leitenden Schichten;

Fig. 18c    eine Aufsichts- und Querschnittsdarstellung zweier mittels Überlappung kapazitiv verbundener elektrisch leitenden Schichten;

Fig. 18d    eine Aufsichtsdarstellung zweier mittels Fingerkapazitäten kapazitiv verbundener elektrisch leitenden Schichten;

Fig. 19a    eine Abwicklungsdarstellung einer ungeschlitzten Abschirmanordnung mit schematischer Darstellung des Stromverlaufs gemäß dem Stand der Technik;

Fig. 19b    eine Abwicklungsdarstellung einer in z-Richtung geschlitzten Abschirmanordnung mit schematischer Darstellung des Stromverlaufs gemäß dem Stand der Technik;

Fig. 20a    eine graphische Auftragung des senkrechten magnetischen Flusses in Abhängigkeit von z;

Fig. 20b    eine Abwicklungsdarstellung einer radial und in z-Richtung geschlitzten Abschirmanordnung für einen magnetischen Fluss nach Fig. 20a gemäß dem Stand der Technik; und

Fig. 21    Querschnittsdarstellungen in xy-Ebene einer vierfach in z-Richtung geschlitzten Abschirmanordnung mit den entsprechenden Moden gemäß dem Stand der Technik.

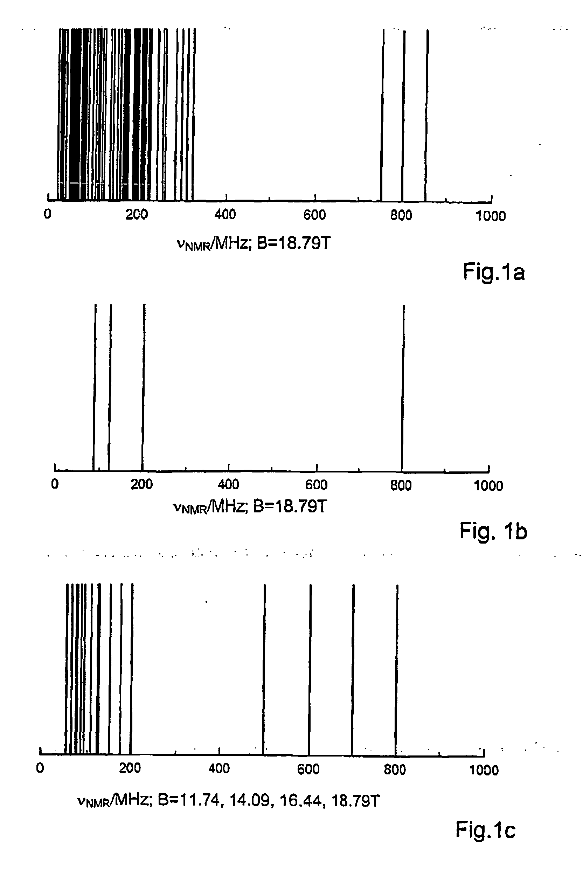

Die Messfrequenzen der wichtigsten NMR-Kerne treten in zwei "Gruppen" auf, wie in **Fig. 1a** dargestellt:

$^3$H, $^1$H und $^{19}$F haben ein $\gamma$ von 25-28 $10^7$ rad/Ts. Der nächste relevante Kern ist $^{31}$P mit $\gamma$ von 10.8 $10^7$ rad/Ts, d.h. 2.5-mal tiefer als die drei anderen Kerne. Die weiteren relevanten Kerne für die NMR füllen das Spektrum bis hinab zu $\gamma = 0.69$ $10^7$ rad/Ts ($^{41}$K). Für eine Protonenfrequenz von 800 MHz bedeutet dies z.B, dass eine Lücke zwischen 324 MHz und 753 MHz besteht, in der keinerlei Messfrequenzen liegen.

Dies kann prinzipiell dazu verwendet werden, dass eine Abschirmanordnung lediglich so konzipiert wird, dass sie keine Eigenresonanz in der Nähe einer (oder mehrerer der drei) Kerne mit hohem Gamma aufweist und die Kerne mit niedrigeren Resonanzfrequenzen geometrisch entkoppelt werden. Hierzu muss lediglich eine Lücke des Spektrums der Abschirmanordnung durch Anpassen der kapazitiven Kopplungen zwischen den Elementen so platziert werden, dass die Eigenmoden unter und oberhalb der Gruppe hoher Frequenzen zu liegen kommen.

In der Praxis haben die meisten Probenköpfe lediglich einen Satz von abstimmbaren Resonanzfrequenzen. Ein typischer NMR-Probenkopf enthält die folgenden Messfrequenzen: $^{15}N$, $^{2}H$, $^{13}C$, $^{1}H$. Sein Spektrum (bei 18.79 T) ist aus **Fig. 1b** ersichtlich.

Betrachtet man Messköpfe für verschiedene Magnetfeldstärken, mit den für die Hochfeldspektroskopie gängigen 1H-Resonanzfrequenzen im Bereich von 500-800 MHz, so bleibt eine große Lücke im Spektrum bestehen. Es besteht daher die Möglichkeit eine Abschirmanordnung zu konzipieren, die für alle gängigen Messfrequenzen universell verwendbar ist.

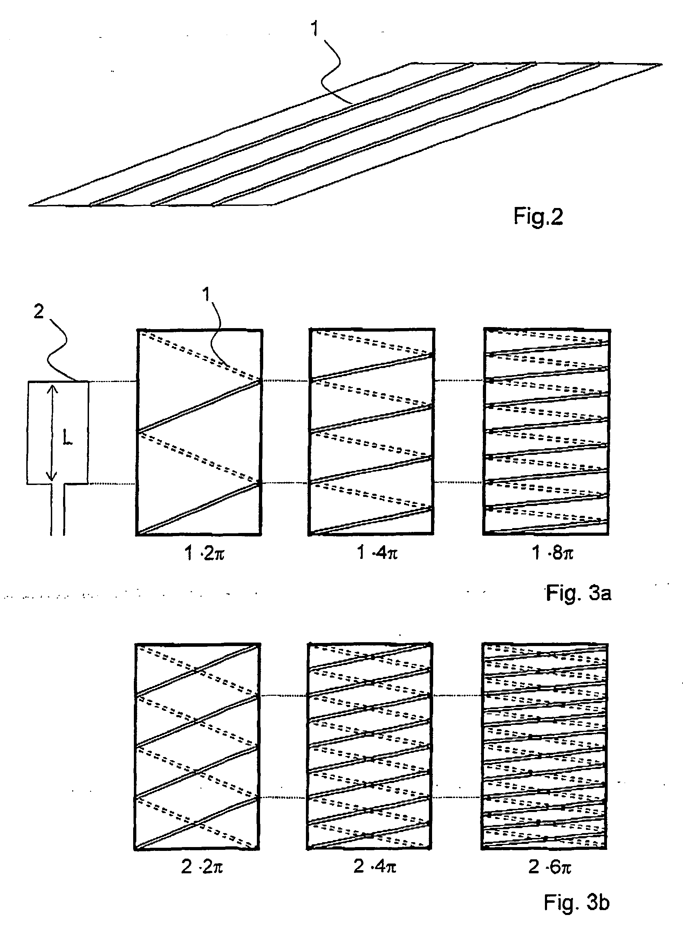

Die in den Fig. 2 bis 9 dargestellten Ausführungsformen der erfindungsgemäßen Abschirmanordnung beziehen sich auf eine idealisierte rechteckige Feldverteilung. Für ein realistisches Feldprofil können die Steigung und Periodizität der Schlitze von den in den speziellen Ausführungsbeispielen gezeigten abeichen, wie weiter unten beschrieben.

Um die geometrische Entkopplung für die tieferen Frequenzen zu erreichen, weist eine Ausführungsform der erfindungsgemäßen Abschirmanordnung Schlitze **1** (i = 1, 2, 3, 4,...) auf, die die elektrisch leitende Schicht der Abschirmanordnung in einer Richtung, die eine z-Komponente ungleich 0 aufweist, vollständig durchtrennt. **Fig. 2** zeigt eine Abwicklungsdarstellung einer erfindungsgemäß geschlitzten Abschirmanordnung mit vier Schlitzen. Diese Schlitze 1 sind kapazitiv geschlossen (mittels Überlapp oder diskreter Kondensatoren, wie unten beschrieben), so dass die tiefste Eigenresonanz der Abschirmanordnung deutlich unterhalb aller NMR-Keme, aber auch zwischen zwei beliebigen Frequenzen zu liegen kommen kann.

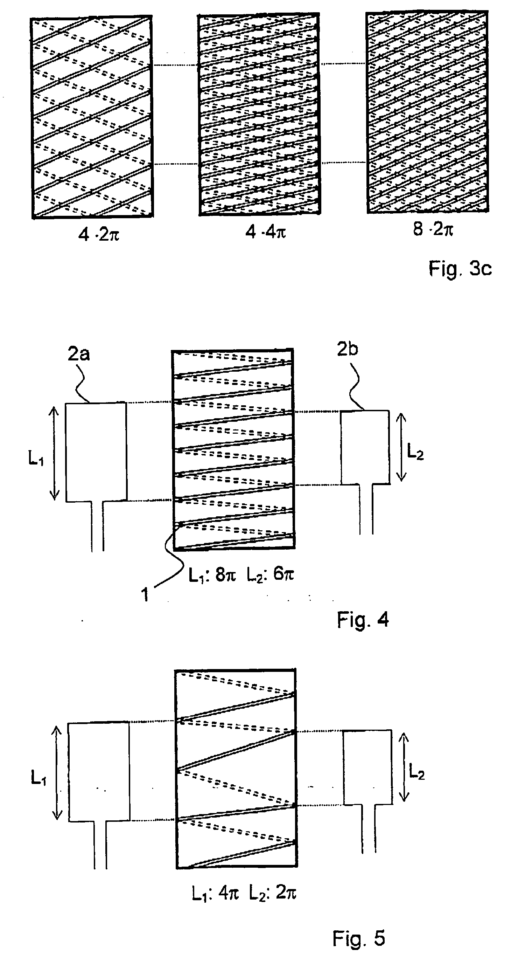

**Fig. 3a-c** zeigen Beispiele für eine Abschirmanordnung für ein Spulen-/Resonatorsystem **2**, wobei die Abschirmanordnung verschiedener Anzahl von Schlitzen 1 mit verschiedenen Periodizitäten aufweisen. Den gezeigten Ausführungsformen ist gemeinsam, dass die Schlitze 1 mit einer $n*2\pi$ - Periodizität über die ungefähre Fensterlänge **L** der Spulen-/Resonatorsystem 2 angeordnet sind. Die Abmessungen der Abschirmanordnung sind so gewählt, dass die axiale Ausdehnung der Abschirmanordnung die Fensterlänge L des Spulen-/Resonatorsystems 2 überragt.

**Fig. 4** zeigt eine Abschirmanordnung für eine Kemspinresonanzapparatur mit zwei Spulen-/Resonatorsystemen **2a, 2b.** Hierbei ist es vorteilhaft, wenn mehr als nur eine $2\pi$ Periodizität der Schlitze 1 vorhanden ist. Insbesondere eine Periodizität (kleinster gemeinsamer Nenner) über die Fensterlängen $L_1$, $L_2$ aller Spulen-/Resonatorsysteme 2a, 2b ist von Vorteil, da in diesem Falle alle Spulen-/Resonatorsysteme 2a, 2b vernachlässigbare Kopplungen aufweisen.

Es muss allerdings nicht unbedingt dieselbe Steigung über die gesamte Innenabschirmung eingehalten werden. Daher können z.B. auch über $L_2$ n*2π rotiert werden und dann nochmals m*2π über $L_1$ - $L_2$. Der Außenbereich kann beliebig gestaltet werden. **Fig. 5** zeigt eine solche Ausführungsform der Abschirmvorrichtung mit einer Periodizität von $4\pi$ innerhalb der Fensterlänge $L_1$ und einer Periodizität von $2\pi$ innerhalb der Fensterlänge $L_2$ der Fensterlänge L.

Darüber hinaus kann zur Minimierung der Kopplung zwischen dem Spulen-/Resonatorsystem 2 und der Abschirmanordnung auch auf eine strikte Periodizität der Schlitze 1 verzichtet werden und stattdessen die Steigung der Feldamplitude des von der Abschirmvorrichtung zu entkoppelnden Spulen-/Resonatorsystems 2 angepasst werden. Die strikte Periodizität der Schlitze 1 geht von einer rechteckförmigen Feldamplitudenverteilung des Spulen-/Resonatorsystem 2 aus, was in Wirklichkeit natürlich nicht gegeben ist. Die schwächeren (oder auch stärkeren) Felder im Randbereich der Fensterlänge L können durch eine lokale Erhöhung (oder Verringerung) der Steigung der Schlitze 1 kompensiert werden. Dies ist insbesondere auch im Außenbereich sinnvoll (ober- und unterhalb der Fensterlänge L), wo das Feld stark abfällt, und wo eine $2\pi$-Periodizität der Schlitze 1 keine ausreichende Entkopplung bringt.

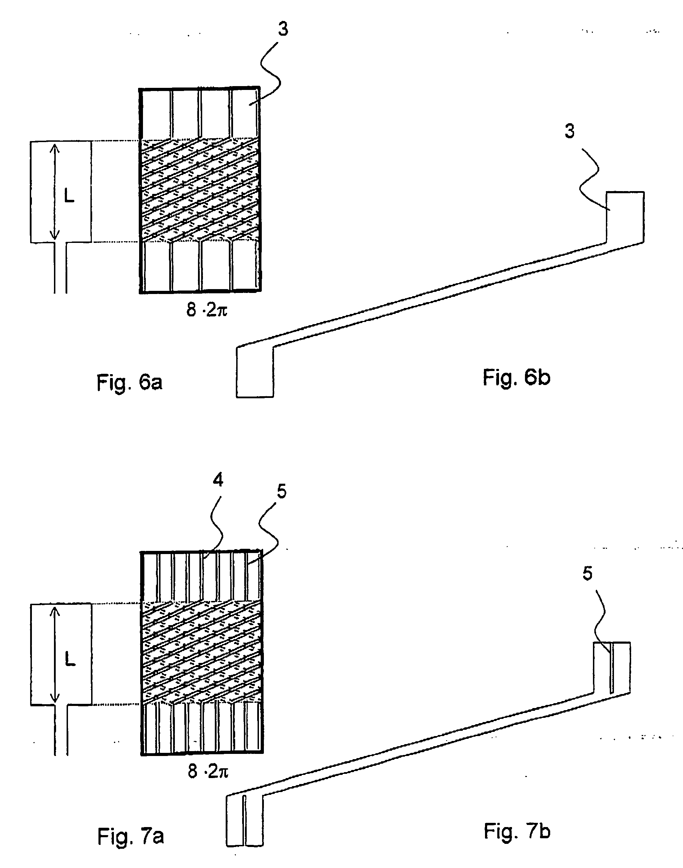

Aus dieser Aussage wird klar, dass die "Periodizität" der Abschirmvorrichtung lediglich im Bereich großer Feldamplitude der Spulen-/Resonatorsysteme vorliegen muss. Im Außenbereich kann auch auf eine konventionelle Form, also mit axialen Schlitzabschnitten **4** (ohne Rotation), übergegangen werden. Eine solche Ausführungsform der elektrisch leitenden Schicht ist in **Fig. 6a** dargestellt. **Fig. 6b** zeigt eine Abwicklungsdarstellung eines Teilstücks **3** der elektrisch leitenden Schicht dieser Abschirmanordnung

Falls die Amplitude der Wirbelströme beim Schalten des Gradienten außerhalb der Fensterlänge L höher sein sollte als innerhalb der Fensterlänge L, so kann es hilfreich sein, die Abschirmvorrichtung außerhalb der Fensterlänge L durch weitere Schlitze **5** weiter zu unterteilen (**Fig. 7a, 7b**). Dies gilt sowohl für die Abschirmanordnung mit durchgehend periodischen Schlitzen 1 als auch für diejenige mit axialen Schlitzabschnitten 4 im Außenbereich. Dabei ist hier nur beispielhaft die maximale Länge der weiteren Schlitze 5 angegeben. Die Abschirmvorrichtung kann auch lediglich in einem kürzeren Bereich geschlitzt sein. Selbst für den Fall, dass die Wirbelströme beim Schalten des Gradienten im Bereich des Fensters am größten sein sollten, kann es Sinn machen, dennoch im Randbereich eine zusätzliche Schlitzung einzuführen, da jeder Schlitz im aktiven Bereich zu gewissen, wenn auch geringen Verlusten führt. Für eine Optimierung der HF-Eigenschaften kann es daher notwendig sein im zentralen Bereich weniger zu schlitzen als im Außenbereich.

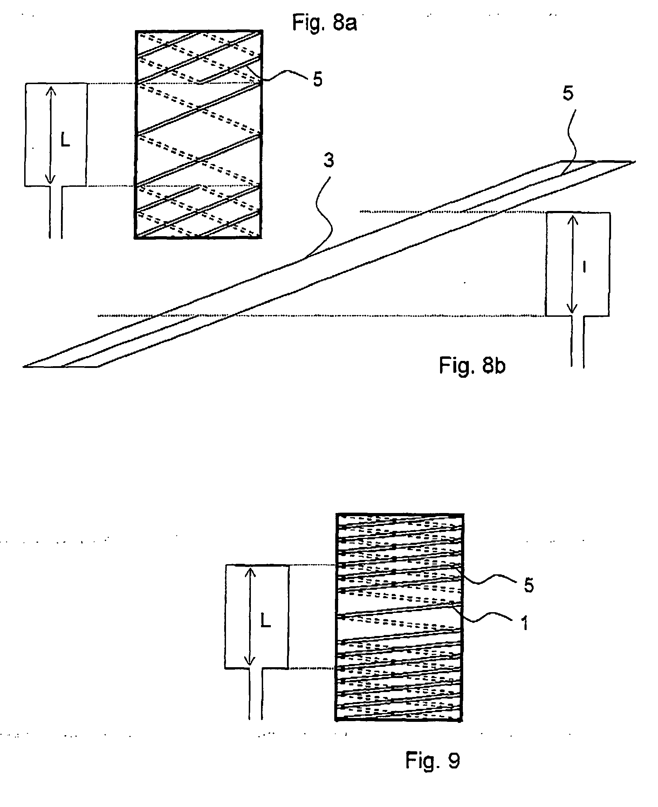

**Fig. 8a, 8b** zeigen Aufsichtsdarstellung einer elektrisch leitenden Schicht einer erfindungsgemäßen Abschirmanordnung beziehungsweise eine Abwicklungsdarstellung eines Teilstücks 3 der elektrisch leitenden Schicht mit spiralförmigen weiteren Schlitzen 5 außerhalb der Fensterlänge L.

Bei einer Periodizität der Schlitze 2 von mehr als $2\pi$ über die Fensterlänge L kann auch ein Teil der Abschirmanordnung im Bereich der Fensterlänge L mittels der zusätzlichen Schlitze 5 noch weiter geschlitzt werden, sofern die zusätzlichen Schlitze 5 insgesamt jeweils noch um $2\pi$ innerhalb der Fensterlänge L rotieren. Dabei können die zusätzliche Schlitze 5 z.B. am unteren und oberen Rand jeweils z.B. um $\pi$ rotiert werden, wie in **Fig. 9** gezeigt.

Die Struktur der bisher gezeigten elektrisch leitenden Schichten sieht der Struktur der "multiply tuned resonant structure" aus [11] und [12] sehr ähnlich. Die entscheidenden Unterschiede sind allerdings die Folgenden:

1. Eine Abschirmanordnung ist keine "resonant coil structure", da sie im Betrieb kein Feld außerhalb der Abschirmanordnung erzeugt, sondern das Feld, das durch die Spulen-/Resonatorsysteme erzeugt wird, auf den Innenraum begrenzt.

2. Die Abschirmanordnung soll im Betrieb des Kernspinresonanzapparates gerade nicht selbst schwingen, da sonst eine Begrenzung des Feldes auf den Innenraum der Abschirmanordnung nicht gewährleistet wäre, d.h. sie soll nicht auf einer Messfrequenz strahlen.

3. Eine Abschirmanordnung ist auch in einem hochauflösenden NMR-Apparat so weit von einem Sample entfernt und so lang, dass sie nicht aus suszeptibilitätskompensiertem Material bestehen muss, wie dies bei bekannten Spulensystemen üblich ist.

4. Die Abschirmanordnung darf nicht zwei geschlossene Leiterringe oben und unten haben. Diese wären von Nachteil, da sie einen durchgehenden Pfad für Wirbelströme beim Schalten der Gradienten schaffen würden.

Damit ist klar, dass es sich bei der erfindungsgemäßen Anordnung trotz der sich auf den ersten Blick ergebenden Ähnlichkeiten um eine völlig andere Struktur handelt.

Wird eine verdrillte Spule gemäß [11] oder [12] als Spulen-/Resonatorsystem 2 verwendet, so sollte die erfindungsgemäße Abschirmanordnung entweder entgegen dem Drehsinn dieser Spule orientiert sein oder, falls der Drehsinn derselbe sein sollte mindestens um $2\pi$ mehr rotieren als die verdrillte Spule.

Je weniger Schlitze 1, 5 in der Abschirmvorrichtung verwendet werden desto einfacher ist das Spektrum der Abschirmanordnung. Bei gleicher Abklingkonstante für die Wirbelströme beim Schalten des Gradientensystems müssen bei weniger Schlitzen 1, 5 mehr Umdrehungen vorgesehen sein. Dadurch verringern sich die Frequenzen der Eigenresonanzen der Abschirmanordnung. Allerdings treten diese nicht in "Paketen" wie "Birdcage-moden", sondern einzeln auf, was das Anpassen an mehrere Messfrequenzen erleichtert.

Wird lediglich ein einziger Schlitz 1 in die Abschirmanordnung eingebracht, weist sowohl die Grundmode als auch die angeregten Moden nur geringfügige Felder in der xy-Ebene auf, und ein Großteil des Feldes ist in z-Richtung orientiert. Dies führt zu einer enormen Verringerung der Kopplung zwischen dem Spulen-/Resonatorsystem 2 und der Abschirmanordnung. Residuelle xy-Felder entstehen durch die Tatsache, dass die Feldamplitude in dem Bereich der Abschirmanordnung, der dem Schlitz 1 gegenüber liegt, am höchsten sind. Dies kommt durch die Tatsache zu Stande, dass die Abschirmanordnung entweder im Bereich ihrer angeregten Moden betrieben wird und/oder die Wellenlängen im Bereich der Messfrequenzen nicht deutlich größer sind als die Abmessungen der Abschirmanordnung. Dadurch handelt es sich weitestgehend um Stehwellen auf der Abschirmanordnung, die zu nicht konstanten Strömen führen. Dieser Bereich wird nun bei der erfindungsgemäßen Abschirmanordnung aufgrund der spiralförmigen Anordnung des Schlitzes 1 um die z-Richtung rotiert, wodurch auch Komponenten in xy-Richtung entstehen. Durch die geschickte Rotation wird die Kopplung global minimiert.

Ein einziger axialer Schlitz 1 ist jedoch in der Regel nicht ausreichend um die ungehinderte Penetration der Gradientenfelder zu garantieren. Durch die Rotation des Schlitzes 1 um die z-Richtung wird zwar der Widerstand für die Wirbelströme erhöht und damit die Zeitkonstante reduziert, weiterhin ist jedoch auch zu beachten, dass eine residuelle Kopplung mit der nur einfach geschlitzten Abschirmanordnung existiert, da die Felder der verschiedenen Moden dieser Abschirmanordnung in der xy-Ebene nicht homogen sind.

Um die Abklingzeiten der Wirbelströme positiv zu beeinflussen, können weiterhin natürlich auch radiale Unterteilungen eingeführt werden. Dies ist insbesondere dann vorteilhaft, wenn die dadurch entstehenden Teilstücke noch jeweils mindestens um $2\pi$ innerhalb der Fensterlänge rotieren, aber auch dann, wenn die Kapazitäten zwischen diesen Teilstücken groß genug sind, damit sie für die Eigenmoden im Bereich der Messfrequenzen elektrisch (kapazitiv) verbunden sind. Diese zusätzlichen radialen Unterteilungen sind bei einem z-Gradienten besonders hilfreich, wenn sie die Abschirmanordnung in der Symmetrieebene des Gradienten schneiden, da die Abschirmströme auf der oberen und unteren Halbebene entgegengesetzt fließen. Insbesondere wenn die Teilstücke der Abschirmanordnung in z-Richtung noch jeweils mindestens um $2\pi$ innerhalb der Fensterlänge L rotieren, müssen die zusätzlichen Schlitze 4 entlang der z-Richtung nicht mehr über die gesamte z-Richtung durchgehend sein.

Auch der Rotationssinn der Schlitze 1 muss nicht einheitlich sein. Die Schlitze 1 der Abschirmanordnung können auch über die Fensterlänge L z.B, insgesamt 2π nach rechts und weitere 2π nach links drehen.

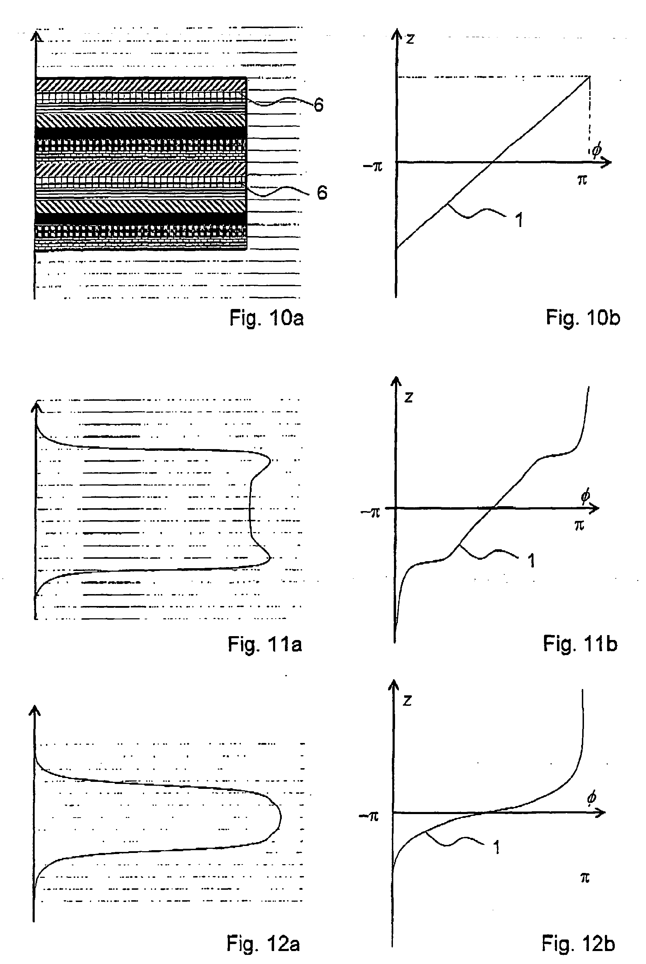

Des Weiteren muss die Periodizität nicht exakt 2π über die Fensterlänge L betragen. Diese Regel gilt lediglich im Falle eines rechteckigen Feldprofils. **Fig. 10a** zeigt ein solches rechteckiges Feldprofil in z-Richtung (parallel zum statischen Magnetfeld) eines (theoretischen) idealen Spulen-/Resonatorsystems 2, für welches in **Fig. 10b** die z-Position eines Schlitzes 1 in Abhängigkeit vom Umdrehungswinkel Φ graphisch dargestellt ist.

In der Darstellung des Feldprofils in Fig. 10a ist die z-Richtung in äquidistante Bereiche **6** eingeteilt. Wird nun eine 2π-Rotation des Schlitzes 1 über die Länge des Feldes durchgeführt, so findet man immer ein Paar von Bereichen 6 (durch gleiche Schraffur markiert), die exakt entgegengesetzte Kopplungen aufweisen, da sie immer eine geometrische Verschiebung von π gegeneinander aufweisen.

Dies ist gültig im Falle, dass die Moden der Abschirmanordnung einen quasi konstanten Strom über die Fensterlänge L des Spulen-/Resonatorsystems 2 aufweisen. Dies wiederum ist dann erfüllt, wenn entweder die kapazitiven Kopplungen der Teilstücke der elektrisch leitenden Schicht der Abschirmanordnung groß genug sind oder die Abschirmanordnung lang genug ist, um für einen hinreichend konstanten Strom auf der Abschirmanordnung im Feldbereich des Spulen-/Resonatorsystems 2 zu sorgen.

Ein realistisches Spulen-/Resonatorsystem 2 hat flache Flanken und je nach Länge entweder "Kamelhöcker" (**Fig. 11a**) oder eine Beule" (**Fig. 12a**). In diesem Falle kann zur Verringerung der Kopplung die Steigung der rotierenden Schlitze 1 der Innenabschirmung auch variabel ausgeführt werden (**Fig. 11b, 12b**). Dasselbe gilt auch für den Fall, in dem man nicht auf die Grundmode sondern auf eine höhere Mode (mit i Knoten) der Abschirmanordnung kompensieren möchte.

Ein großer Vorteil der erfindungsgemäßen Abschirmanordnung ist, dass sie vollständig kompatibel zu Quadraturspulen ist, da sie keinerlei präferenzielle Richtung aufweist.

Wird die Steigung der Schlitze 1 der Abschirmanordnung immer flacher (= Periodizität n*2π mit n gegen unendlich), so wird die präzise Einhaltung der Periodizität über die Fensterlänge L immer unwichtiger. Im Grenzfall rotieren die Schlitze 1 in Umfangsrichtung der Abschirmanordnung, so dass die Moden unabhängig von der Periodizität immer senkrecht stehen und daher entkoppelt sind. Residuelle Kopplungen mitteln sich durch die hohe Umdrehungszahl weg. Allerdings ist es in diesem Fall sehr schwierig noch ausreichende Kapazität für die Abschirmung der HF-Felder zu gewährleisten, was die Anzahl der Umdrehungen limitiert. Im Falle eines typischen NMR-Probenkopfes mit Fensterlänge L im Bereich von 20 mm sind maximal 4-5 Umdrehungen sinnvoll. Im Experiment zeigt sich, dass die residuellen Kopplungen selbst bei geringer Anzahl von Umdrehungen (2π-8π) ausreichend klein sind um auf eine absolute Auslöschung der Kopplungen verzichten zur können. In diesem Falle ist auch die Einhaltung einer exakten "Periodizität" unwichtig.

Die Funktionsweise der bisher beschriebenen Ausführungsformen der erfindungsgemäßen Abschirmanordnung ist es, mittels einer "2π-Periodizität" die integrale Kopplung über z zu minimieren.

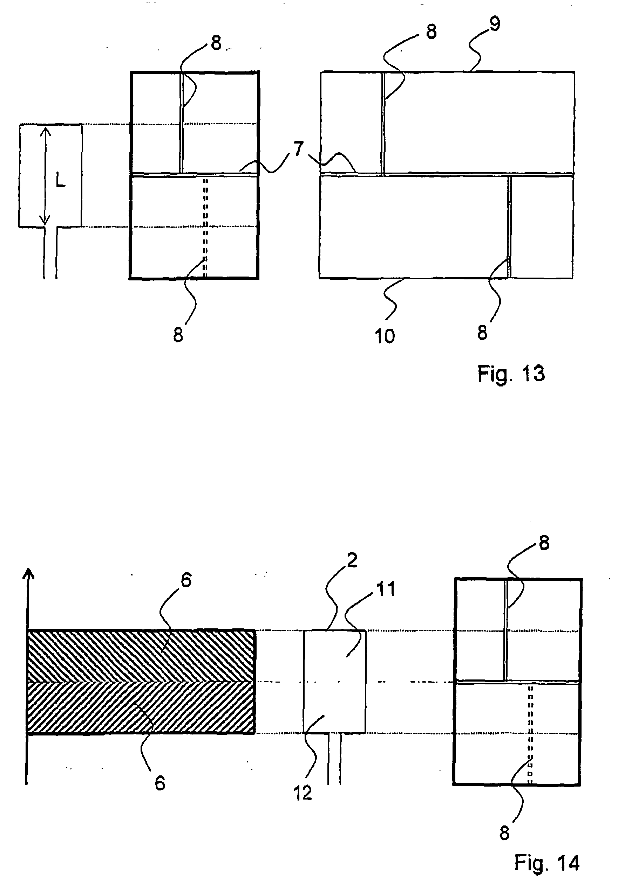

Bei einer alternativen Ausführungsform der erfindungsgemäßen Abschirmanordnung (zweite Ausführungsform) "kollabiert" diese Periodizität in einen Punkt. Diese alternative Ausführungsform sieht mindestens drei Schlitze **7, 8** vor: mindestens einen radialen Schlitz 7 und je einen axial von diesem ausgehender Schlitz 8, der bis zur oberen **9** bzw. unteren Endkante **10** der Abschirmanordnung reicht, wobei die beiden axialen Schlitze 8 eine 180° Rotation gegeneinander aufweisen, wie in **Fig. 13** gezeigt.

Es wird also eine Punktsymmetrie eingeführt, so dass wieder jeweils zwei Bereiche 6 entgegengesetzte Kopplung aufweisen (**Fig. 14**). Dies kommt daher, dass ein ideales Spulen-/Resonatorsystem eine magnetische Symmetrieebene in der xy-Ebene aufweist (bei nicht idealen Spulen-/Resonatorsystemen 2 ist diese Symmetrie nicht vollständig aber immerhin weitestgehend erfüllt). Dabei ist es lediglich erforderlich, dass der axial obere Teil **11** der Abschirmanordnung eine Drehung um π gegenüber dem unteren Teil **12** aufweist, d.h. es existiert eine Punktsymmetrie um das Zentrum des Spulen-/Resonatorsystems 2. Diese Punktsymmetrie steht im Gegensatz zur Spiegelsymmetrie des Spulen-/Resonatorsystems 2 und führt zur Auslöschung der Kopplung zwischen Spulen-/Resonatorsystem 2 und Abschirmanordnung.

Die Kopplung, die zwischen dem oberen Teil 11 der Abschirmanordnung und dem Spulen-/Resonatorsystem 2 entsteht, ist genau entgegengesetzt zu derjenigen, die im unteren Teil 12 entsteht (wenn man den Symmetriebruch durch die Anschlussbeine des Spulen-/Resonatorsystem vemachlässigt). Dass das Spulen-/Resonatorsystem 2 überhaupt in die Abschirmanordnung koppelt, kann folgendermaßen verstanden werden: Ein einziges Spulen-/Resonatorsystem 2 kann mit einer Abschirmanordnung, die zwei axiale Schlitze 8 aufweist, so orientiert werden, dass alle Moden des Spulen-/Resonatorsystems 2 und der Abschirmanordnung senkrecht aufeinander stehen. Hat die Abschirmanordnung lediglich einen Schlitz 8 oder mehr als zwei Schlitze 8 in axialer Richtung, so ist diese Ausrichtung nicht mehr möglich, da die Abschirmanordnung in diesem Falle die elektrischen und magnetischen Symmetrieebenen des Spulen-/Resonatorsystems 2 (xz- und yz- Ebene) brechen. Dasselbe gilt selbstverständlich für ein weiteres Spulen-/Resonatorsystem 2, das weitestgehend senkrecht zu dem ersten orientiert ist.

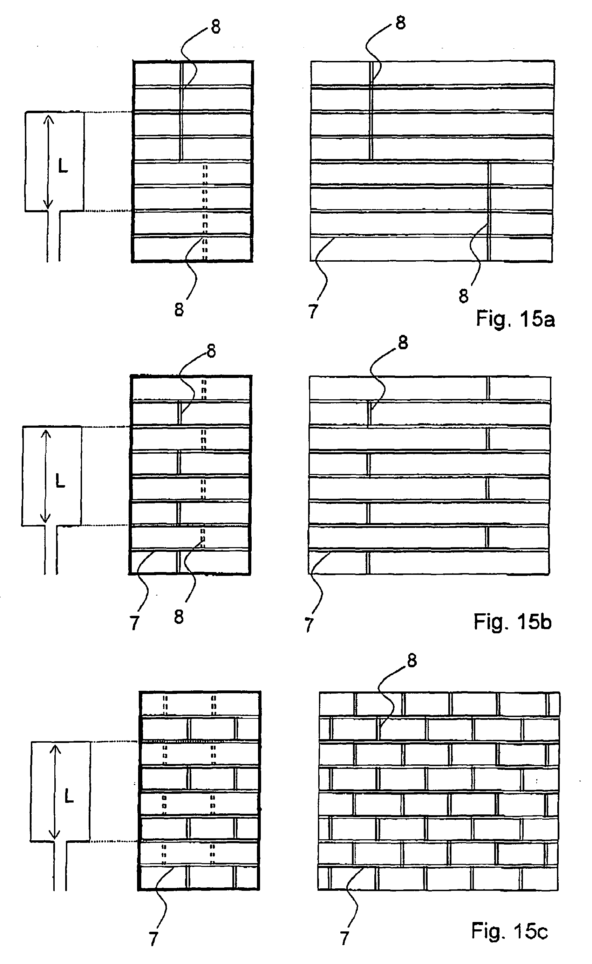

Wie in **Fig. 15a, 15b, 15c** gezeigt, ist es auch möglich mehr Schlitze 7, 8 vorzusehen. Dabei ist es lediglich erforderlich, dass die Punktsymmetrie um das Zentrum der Abschirmanordnung herum erhalten bleibt. Um eine Positionierung der Abschirmanordnung bezüglich zweier Spulen-/Resonatorsysteme 2 möglich zu machen, ist es weiterhin hilfreich, die magnetische und elektrische Symmetrie in x- und y-Ebene der Spulen-/Resonatorsysteme 2 ebenfalls so zu brechen, dass die Kopplungen mit den beiden Teilen 11, 12 der Abschirmanordnung (oberhalb und unterhalb des Zentrums) für alle Spulen-/Resonatorsysteme 2 in etwa identisch sind. Konkret heißt dies, dass im Falle von axialen Schlitzen 8 diese unter 45° zu den Symmetrieebenen der beiden Spulen-/Resonatorsysteme 2 orientiert sein müssen, falls ein System von orthogonalen Spulen-/Resonatorsystemen 2 entkoppelt werden soll. Die Ausrichtung kann daher erleichtert werden, wenn eine ungeradzahlige Anzahl von Schlitzen 7, 8 in jeden Teil der Abschirmanordnung eingefügt werden.

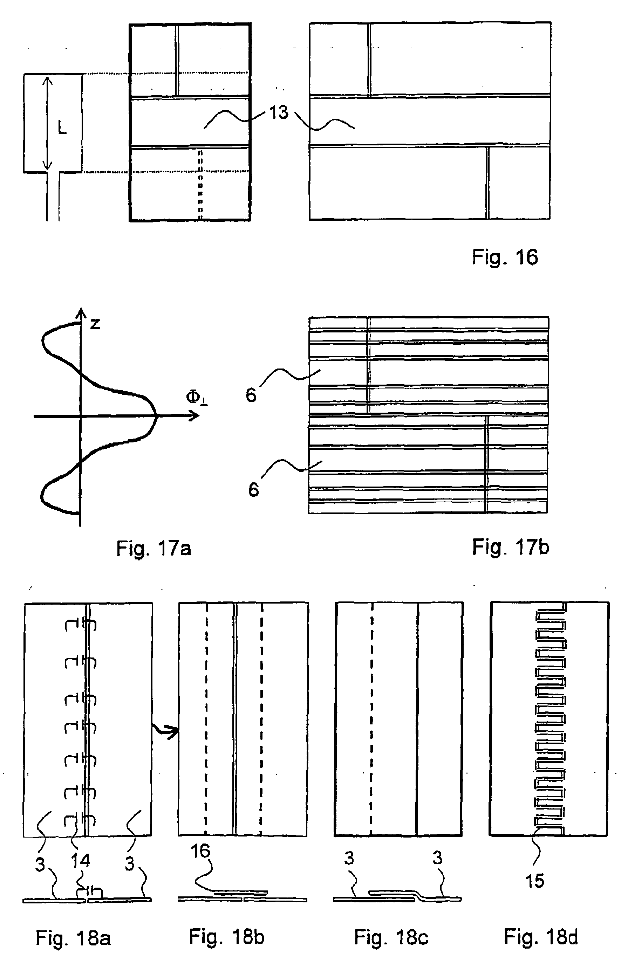

**Fig. 16** zeigt, dass es prinzipiell auch möglich ist, in einem Bereich **13** in der Mitte der Fensterlänge L überhaupt nicht zu schlitzen, da hier aus Symmetriegründen beim Abklingen des Gradienten keine beziehungsweise nur geringe Spiegelströme generiert werden.

Möchte man die Recovery-Eigenschaften der Abschirmanordnung optimieren, so kann man die Schlitzung in z-Richtung so durchführen, dass der Fluss senkrecht zur Abschirmanordnung, der die jeweiligen Bereiche 6 in z-Richtung durchdringt, in etwa ungestört ist (**Fig. 17a**). Bei einem z-Gradienten sieht dies in etwa so aus wie in **Fig. 17b** gezeigt.

Bei beiden Typen von Abschirmanordnung löschen sich die Kopplungen zwischen den Spulen-/Resonatorsystemen 2 und den verschiedenen Moden der Abschirmanordnung natürlich lediglich für die Moden aus, welche die gebrochene Symmetrie aufweisen. In der Regel wird das Design so sein, dass die tiefste Mode dieses Kriterium erfüllt. Andererseits kann die Abschirmanordnung aber auch so ausgelegt werden, dass eine Auslöschung für höhere Moden auftritt. Vorteilhafterweise weisen auch die Moden, die nicht optimiert wurden, in der Regel immer noch deutlich niedrigere Kopplungen auf als es für eine Abschirmanordnung mit rein axialen Schlitzen, wie sie aus dem Stand der Technik bekannt sind, der Fall ist. In der Regel ist eine vollständige Auslöschung der Kopplung gar nicht notwendig. Eine Dämpfung von 30-40 dB reicht völlig aus, solange die Messfrequenzen nicht exakt auf die Eigenmoden der Abschirmanordnung fallen.

Eine weitere mögliche Ausführungsform der erfindungsgemäßen Abschirmanordnung stellt eine Mischform aus den beiden bisher alternativ diskutierten Ausführungsformen dar (nicht dargestellt). Dabei kann jeder Teilbereich der Abschirmanordnung mit Punktsymmetrie einen Schlitz 1 beinhalten, der mindestens eine Umdrehung in der z-Richtung durchfährt wobei die gesamte Struktur eine Punktsymmetrie aufweist. Diese Ausführungsform minimiert die Kopplung jedes einzelnen Teilstücks 3 der Abschirmanordnung mit dem Resonatorsystem 2 und reduziert die residuelle Kopplung durch geometrische Auslöschung von zwei Bereichen 6,

Damit die HF-Verluste bei den verschiedenen Ausführungsformen der erfindungsgemäßen, nicht koppelnden Abschirmanordnung so gering wie möglich gehalten werden können, sollte eine kapazitive Verbindung **14** zwischen den einzelnen Teilstücken 3 der elektrisch leitenden Schichten der Abschirmanordnung vorgesehen sein (**Fig. 18a**). Diese kann entweder durch diskrete Kondensatoren, wie aus dem Stand der Technik bekannt, oder durch verteilte Kapazitäten durch Überlapp der einzelnen Teilstücke 3 der elektrisch leitenden Schichten (**Fig. 18b, 18c**) erreicht werden. Eine Kombination ist ebenfalls möglich. Durch das Anbringen der kapazitiven Elemente wird das Eigenmodespektrum der Abschirmanordnung modifiziert (Frequenz der Eigenmoden sinkt).

Bei der Ausführungsform der erfindungsgemäßen Abschirmanordnung mit Schlitzen 1, welche die elektrisch leitende Schicht der Abschirmanordnung in einer Richtung, die eine z-Komponente ungleich 0 aufweist, vollständig durchtrennt (erste Ausführungsform) können die verteilten Kapazitäten sowohl durch eine entsprechende Struktur mit entgegengesetztem Drehsinn als auch mit gleichgerichtetem Drehsinn erzeugt werden. Außerdem müssen die elektrisch leitenden Schichten nicht dieselbe Periodizität und Anzahl von Schlitzen 1 aufweisen. Es können auch noch weitere zusätzliche elektrisch leitende Schichten aufgebracht werden um eventuell noch "durchsickernde" Felder weiter abzuschirmen. Bei der zweiten Ausführungsform kann eine äquivalente Struktur einer elektrisch leitenden Schicht um die halbe Höhe gegenüber einer ersten elektrisch leitenden Schicht verschoben werden, wobei im Idealfall der um die Mitte zentrierte Bereich 13 keinen Schlitz 1 aufweist.

Die am einfachsten herzustellende Ausführungsform für verteilte Kapazitäten ist eine Ausführung auf einer Laminatfolie, welche ein dünnes Dielektrikum darstellt, das beidseitig mit 2-10 Eindringtiefen dickem Metall beschichtet ist.

Die geometrisch einfachste Form (wenn auch schwieriger herzustellen) ist es, dünne Metallfolien auf einen Träger zu befestigen und voneinander mittels nicht leitender Folie (z.B. aus einem Fluorpolymer, Kapton oder ähnlichem) oder Lack zu isolieren. Dabei kann durch Überlappung eine Kapazität erzeugt werden (Fig. 18b, 18c).

Eine weitere Ausführungsform sieht vor, die Kapazitäten zwischen den Teilstücken 3 der elektrisch leitenden Schicht mittels Fingerkapazitäten **15** entlang der Schlitze zu realisieren (**Fig. 18d**).

Des Weiteren kann ein dielektrischer Träger (Saphir-Rohr/Polyeder, auch aus Kunststoff, Aluminiumnitrid etc...) mit einer gut leitenden, dünnen Schicht beschichtet werden. Diese Schicht kann zur Abschirmanordnung strukturiert werden. Nun können entweder diskrete kapazitive Elemente eingebaut werden oder eine verteilte Kapazität geschaffen werden. Letzteres kann durch Beschichten mit einem Dielektrikum und weiterem Beschichten mit einer zweiten elektrisch leitenden Schicht **16** durchgeführt werden oder erneut durch Strukturierung von Fingerkondensatoren. Alternativ kann eine einseitig beschichtete Laminatfolie auf den strukturierten Träger aufgebracht werden (Spannen, klemmen, kleben...) oder eine dielektrische Schicht und eine Metallfolie befestigt werden.

## Referenzliste

[1] US 4,310,799 A1

[2] US 4,506,224 A1

[3] US 4,642,569 A1

[4] US 4,871,969 A1

[5] US 4,879,515 A1

[6] US 5,243,286 A1

[7] US 5,381,093 A1

[8] US 5,572,129 A1

[9] US 5,574,372 A1

[10] US 5,680,046 A1

[11] US 6,420,871 B1

[12] US 2004/189304 A1

[13] WO 01/78089 A1

## Bezugszeichenliste

| | |
|---|---|
| L | Fensterlänge des Spulen-/ Resonatorsystems |
| 1 | Schlitz mit Anteil in z-Richtung |
| 2 | HF-Spulen-/Resonatorsystem |
| 3 | Teilstück der Abschirmanordnung |
| 4 | axiale Schlizabschnitte |
| 5 | weiterer Schlitz |
| 6 | Bereich |
| 7 | Schlitz in Umfangsrichtung durchgehend |
| 8 | axiale Schlitze nicht durchgehend |
| 9 | obere Endkante der Abschirmanordnung |
| 10 | untere Endkante der Abschirmanordnung |
| 11 | oberer Teil der Abschirmanordnung |
| 12 | unterer Teil der Abschirmanordnung |
| 13 | Bereich in der Mitte des Fensterlänge I |
| 14 | kapazitive Verbindung |
| 15 | Fingerkapazität |
| 16 | zweite elektrisch leitende Schicht |

## Patentansprüche

**1.** Kernspinresonanzapparatur zur Erzeugung eines homogenen statischen Magnetfelds in einer z-Richtung, mit

- mindestens einem Spulen-/Resonatorsystem, das dem Senden und/oder Empfangen von Hochfrequenz(HF)-Signalen auf mindestens einer Messfrequenz dient,
- einem Gradientensystem, das zur Erzeugung von gepulsten Feldgradienten in mindestens einer Raumrichtung dient, und
- einer Abschirmanordnung, die radial bezüglich der z-Richtung zwischen dem mindestens einen Spulen-/Resonatorsystem und dem Gradientensystem positioniert ist, wobei die Abschirmanordnung zylindermantelförmig ist und mindestens eine elektrisch leitende Schicht mit mindestens einem Schlitz (1, 7, 8) umfasst, wobei die elektrisch leitende Schicht zur z-Richtung axialsymmetrisch um den Mittelpunkt der Abschirmanordnung angeordnet ist, und der mindestens eine Schlitz (1, 7, 8) die mindestens eine elektrisch leitende Schicht in einer Richtung, die eine z-Komponente ungleich 0 aufweist, vollständig durchtrennt und in Teilstücke (3) unterteilt,
- wobei die Abschirmanordnung in einem axialen Abschnitt $z1 < z < z2$, mit $z2 - z1 > L$, wobei L = Fensterlänge des Spulen-/Resonatorsystems, in der mindestens 90% der magnetischen Feldenergie des Spulen-/Resonatorsystems enthalten ist, mindestens ein Paar von zylindermantelförmigen Bereichen (6) um die z-Richtung aufweist, wobei die zwei Bereiche (6) eines jeden Paares jeweils durch zwei um die z-Richtung umlaufende, in sich geschlossene Grenzlinien definiert sind, und wobei die zwei Grenzlinien jedes Bereichs (6) einen axialen Abstand $a \leq \dfrac{z2 - z1}{2}$ voneinander aufweisen und auf Ebenen parallel zur xy-Ebene, d.h. senkrecht zur z-Richtung, liegen,

**dadurch gekennzeichnet, dass**

- die beiden Bereiche (6) eines solchen Paares aufgrund der Geometrie der Abschirmanordnung für mindestens eine Eigenmode der Abschirmanordnung entgegengesetzte induktive Kopplungen mit dem mindestens einen Spulen-/Resonatorsystem aufweisen,
- indem der mindestens eine Schlitz (1, 7, 8) so angeordnet ist, dass jedes der Teilstücke (3) innerhalb der Fensterlänge L des mindestens einen Spulen-/Resonatorsystems mindestens einmal vollständig um die z-Richtung rotiert.

2. Kernspinresonanzapparatur nach Anspruch 1 **dadurch gekennzeichnet dass** bei mindestens einem Schlitz (1) der elektrisch leitenden Schicht der Abschirmanordnung die Steigung bezüglich der z-Richtung über den gesamten Abschnitt $z1 < z < z2$ der Abschirmanordnung gleichmäßig verläuft.

3. Kernspinresonanzapparatur nach einem der vorhergehenden Ansprüche, **dadurch gekennzeichnet, dass** mindestens ein Schlitz (1) der elektrisch leitenden Schicht der Abschirmanordnung ein ganzzahliges Vielfaches von Umdrehungen um die z-Richtung entlang der Fensterlänge L einer oder aller HF-Spulen-/Resonatorsysteme aufweist.

4. Kernspinresonanzapparatur nach einem der vorhergehenden Ansprüche, **dadurch gekennzeichnet, dass** zusätzlich zu dem mindestens einen Schlitz (1), der die elektrisch leitende Schicht der Abschirmanordnung vollständig durchtrennt, mindestens ein weiterer Schlitz (5) vorgesehen ist, der an einer Endkante der Abschirmanordnung beginnend die elektrisch leitende Schicht nicht vollständig durchtrennt.

5. Kernspinresonanzapparatur nach Anspruch 4 **dadurch gekennzeichnet, dass** mindestens einer der weiteren Schlitze (5) ausschließlich außerhalb der Fensterlänge L des mindestens einen Spulen-/ Resonatorsystems verläuft.

6. Kernspinresonanzapparatur nach Anspruch 4 **dadurch gekennzeichnet, dass** die weiteren Schlitze (5) innerhalb der Fensterlänge L des mindestens einen Spulen-/Resonatorsystems mindestens einmal vollständig um die z-Richtung rotiert sind.

7. Kernspinresonanzapparatur nach einem der vorhergehenden Ansprüche, **dadurch gekennzeichnet, dass** die Schlitze (1, 5) außerhalb der Fensterlänge L des mindestens einen HF-Spulen-/Resonatorsystems eine niedrigere oder eine höhere Steigung bezüglich der z-Richtung als innerhalb der Fensterlänge L aufweisen.

8. Kernspinresonanzapparatur zur Erzeugung eines homogenen statischen Magnetfelds in einer z-Richtung, mit

- mindestens einem Spulen-/Resonatorsystem, das dem Senden und/oder Empfangen von Hochfrequenz(HF)-Signalen auf mindestens einer Messfrequenz dient,
- einem Gradientensystem, das zur Erzeugung von gepulsten Feldgradienten in mindestens einer Raumrichtung dient, und
- einer Abschirmanordnung, die radial bezüglich der z-Richtung zwischen dem mindestens einen Spulen-/Resonatorsystem und dem Gradientensystem positioniert ist, wobei die Abschirmanordnung zylindermantelförmig ist und mindestens eine elektrisch leitende Schicht mit mindestens einem Schlitz (1, 7, 8) umfasst, wobei die elektrisch leitende Schicht zur z-Richtung axialsymmetrisch um den Mittelpunkt der Abschirmanordnung angeordnet ist, und der mindestens eine Schlitz (1, 7, 8) die mindestens eine elektrisch leitende Schicht vollständig durchtrennt und in Teilstücke (3) unterteilt,
- wobei die Abschirmanordnung in einem axialen Abschnitts $z1 < z < z2$, mit $z2 - z1 > L$, wobei L = Fensterlänge des Spulen-/Resonatorsystems, in der mindestens 90% der magnetischen Feldenergie des Spulen-/Resonatorsystems enthalten ist, mindestens ein Paar von zylindermantelförmigen Bereichen (6) um die z-Richtung aufweist, wobei die zwei Bereiche (6) eines jeden Paares jeweils durch zwei um die z-Richtung umlaufende, in sich geschlossene Grenzlinien definiert sind, und wobei die zwei Grenzlinien jedes Bereichs (6) einen axialen Abstand $a \leq \dfrac{z2 - z1}{2}$ voneinander aufweisen und auf Ebenen parallel zur xy-Ebene, d.h. senkrecht zur z-Richtung, liegen,

**dadurch gekennzeichnet, dass**

- die beiden Bereiche (6) eines solchen Paares aufgrund der Geometrie der Abschirmanordnung für mindestens eine Eigenmode der Abschirmanordnung entgegengesetzte induktive Kopplungen mit dem mindestens einen Spulen-/Resonatorsystem aufweisen,
- indem der mindestens eine Schlitz (7) der elektrisch leitenden Schicht der Abschirmanordnung durchgehend parallel zur xy-Ebene verläuft, wobei die Anordnung des mindestens einen Schlitzes (7), der parallel zur xy-Ebene verläuft, spiegelsymmetrisch in Bezug auf die xy-Ebene ist und zumindest in einem zentralen Bereich der Fensterlänge L zusätzlich mindestens ein Paar von axialen Schlitzen (8) vorgesehen ist, wobei die axialen Schlitze (8) parallel zur z-Richtung orientiert sind und jeweils zwei benachbarte parallel zur xy-Ebene verlaufende Schlitze (7) oder einen parallel zur xy-Ebene verlaufenden Schlitz (7) und eine Endkante (9) der elektrisch leitenden Schicht der Abschirmanordnung verbinden, wobei die gesamte Anordnung der Schlitze (7, 8) eine Punktsymmetrie bezüglich des Mittelpunkts der Abschirmanordnung, aber keine Spiegelsymmetrie zu der xy-Ebene aufweist, welche durch das Zentrum des Spulen-/Resonatorsystems verläuft.

9. Kernspinresonanzapparatur nach Anspruch 8, **dadurch gekennzeichnet dass** ein Bereich (13) der Abschirmanordnung in der Mitte der Fensterlänge L existiert, der keinen Schlitz aufweist.

10. Kernspinresonanzapparatur nach Anspruch 8, **dadurch gekennzeichnet dass** alle Bereiche (6) der Abschirmanordnung in z-Richtung jeweils einen axialen Schlitz (8) aufweisen.

11. Kernspinresonanzapparatur nach einem der Ansprüche 8 bis 10, **dadurch gekennzeichnet dass** die Abstände benachbarter parallel zur xy-Ebene verlaufender Schlitze (7) jeweils identisch sind.

12. Kernspinresonanzapparatur nach einem der Ansprüche 8 bis 10, **dadurch gekennzeichnet dass** die Abstände benachbarter parallel zur xy-Ebene verlaufender Schlitze (7) im Bereich der Mitte der Fensterlänge L geringer sind als außerhalb der Fensterlänge L.

13. Kernspinresonanzapparatur nach einem der vorhergehenden Ansprüche, **dadurch gekennzeichnet, dass** die Abschirmanordnung entweder genau eine elektrisch leitende Schicht und kapazitive Elemente (14, 15) aufweist, die über den mindestens einen Schlitz (1, 7, 8) angebracht sind, so dass HF-Ströme im Bereich der Messfrequenz weitestgehend ungehindert fließen können, oder zwei elektrisch leitende Schichten umfasst, zwischen denen eine dielektrische, nicht leitende Schicht angeordnet ist, wobei die Schlitze (1, 7, 8) in den beiden elektrisch leitenden Schichten nicht deckungsgleich verlaufen.

**Claims**

1. Nuclear magnetic resonance apparatus for generating a homogeneous static magnetic field in a z-direction, comprising

 - at least one coil/resonator system for transmitting and/or receiving radio frequency (RF) signals at at least one measuring frequency,
 - a gradient system for generating pulsed field gradients in at least one spatial direction, and
 - a shielding configuration which is positioned radially with respect to the z-direction between the at least one coil/resonator system and the gradient system, wherein the shielding configuration has the shape of a cylinder jacket and comprises at least one electrically conducting layer with at least one slot (1, 7, 8), wherein the electrically conducting layer is disposed axially symmetrically with respect to the z-direction about the center of the shielding configuration, and the at least one slot (1, 7, 8) completely intersects the at least one electrically conducting layer in a direction having a z-component other than 0, dividing it into sections,
 - wherein, in an axial section z1<z<z2 with z2-z1>L, wherein L = window length of the coil/resonator system containing at least 90% of the magnetic field energy of the coil/resonator system, the shielding configuration comprises at least one pair of regions (6) around the z-axis, which have the shape of a cylinder jacket, wherein the two regions (6) of each pair are defined in each case by two self-contained boundary lines that are circumferential about the z-direction, and wherein the two boundary lines of each region (6) have a mutual axial separation from each other $a \le \dfrac{z2 - z1}{2}$ and are disposed on planes parallel to the xy-plane, i.e. perpendicular to the z-direction,

 **characterized in that**

 - the two regions (6) of such a pair have opposite inductive couplings with the at least one coil/resonator system for at least one eigenmode of the shielding configuration due to the geometry of the shielding configuration,
 - the at least one slot (1, 7, 8) is disposed such that each section (3) within the window length L of the at least one coil/resonator system performs at least one full rotation about the z-direction.

2. NMR apparatus according to claim 1, **characterized in that** the slope of at least one slot (1) of the electrically conducting layer of the shielding configuration is continuous in the z-direction throughout the entire section z1<z<z2 of the shielding configuration.

3. NMR apparatus according to any one of the preceding claims, **characterized in that** at least one slot (1) of the electrically conducting layer of the shielding configuration comprises an integer multiple of rotations about the z-axis along the window length L of one or all RF coil/resonator systems.

4. NMR apparatus according to any one of the preceding claims, **characterized in that**, in addition to the at least one slot (1) which completely intersects the electrically conducting layer of the shielding configuration, at least one further slot (5) is provided which starts at an end edge of the shielding configuration and does not completely intersect the electrically conducting layer.

5. NMR apparatus according to claim 4, **characterized in that** at least one of the further slots (5) extends exclusively outside of the window length L of the at least one coil/resonator system.

6. NMR apparatus according to claim 4, **characterized in that** the further slots (5) perform at least one full rotation about the z-axis within the window length L of the at least one coil/resonator system.

7. NMR apparatus according to any one of the preceding claims, **characterized in that** the slots (1, 5) outside of the window length L of the at least one RF coil/resonator system have a lower or a higher slope relative to the z-direction than within the window length L.

8. Nuclear magnetic resonance apparatus for generating a homogeneous static magnetic field in a z-direction, comprising

   - at least one coil/resonator system for transmitting and/or receiving radio frequency (RF) signals at at least one measuring frequency,
   - a gradient system for generating pulsed field gradients in at least one spatial direction, and
   - a shielding configuration which is positioned radially with respect to the z-direction between the at least one coil/resonator system and the gradient system, wherein the shielding configuration has the shape of a cylinder jacket and comprises at least one electrically conducting layer with at least one slot (1, 7, 8), wherein the electrically conducting layer is disposed axially symmetrically with respect to the z-axis about the center of the shielding configuration and the at least one slot (1, 7, 8) completely intersects the at least one electrically conducting layer, dividing it into sections,
   - wherein in an axial section z1<z<z2 with z2-z1>L, wherein L = window length of the coil/resonator system containing at least 90% of the magnetic field energy of the coil/resonator system, the shielding configuration comprises at least one pair of regions (6) around the z-axis, which have the shape of a cylinder jacket, wherein the two regions (6) of each pair are defined in each case by two self-contained boundary lines that are circumferential about the z-direction, and wherein the two boundary lines of each region (6) have a mutual axial separation from each other $a \leq \dfrac{z2 - z1}{2}$ and are disposed on planes parallel to the xy-plane, i.e. perpendicular to the z-direction,

**characterized in that**

   - the two regions (6) of such a pair have opposite inductive couplings with the at least one coil/resonator system for at least one eigenmode of the shielding configuration due to the geometry of the shielding configuration,
   - the at least one slot (7) of the electrically conducting layer of the shielding configuration continuously extends parallel to the xy-plane, wherein the configuration of the at least one slot (7) which extends parallel to the xy-plane, is mirror-symmetrical with respect to the xy-plane and at least one pair of axial slots (8) is additionally provided in a central region of the window length L, wherein the axial slots (8) are oriented parallel to the z-direction, each connecting two neighboring slots (7) that extend parallel to the xy-plane, or one slot (7) that extends parallel to the xy-plane to an end edge (9) of the electrically conducting layer of the shielding configuration, wherein the overall configuration of the slots (7, 8) is point symmetrical with respect to the center of the shielding configuration, but not mirror symmetrical with respect to the xy-plane, which extends through the center of the coil/resonator system.

9. NMR apparatus according to claim 8, **characterized in that** no slots are provided in a region (13) of the shielding configuration in the center of the window of length L.

10. NMR apparatus according to claim 8, **characterized in that** each region (6) of the shielding configuration has an axial slot (8) in the z-direction.

11. NMR apparatus according to any one of the claims 8 through 10, **characterized in that** the separations between neighboring slots (7) that extend parallel to the xy-plane are identical in each case.

12. NMR apparatus according to any one of the claims 8 through 10, **characterized in that** the separations between neighboring slots (7) that extend parallel to the xy-plane are smaller in the region of the center of the window of length L than outside of the window of length L.

13. NMR apparatus according to any one of the preceding claims, **characterized in that** the shielding configuration either comprises exactly one electrically conducting layer and capacitive elements (14, 15) which are disposed over the at least one slot (1, 7, 8), such that RF currents in the region of the measuring frequency can flow largely unperturbed, or comprises two electrically conducting layers between which a dielectric, non-conducting layer is disposed, wherein the slots (1, 7, 8) in the two electrically conducting layers do not extend in a congruent fashion.

## Revendications

1. Appareil de résonance magnétique nucléaire permettant de produire un champ magnétique statique homogène selon une direction z avec

> - au moins un système de bobines ou de résonateur servant à émettre et/ou à recevoir des signaux haute fréquence (HF) sur au moins une fréquence de mesure,
> - un système de gradients servant à produire des gradients de champ à impulsions dans au moins une direction de l'espace, et
> - un agencement d'écran positionné de manière radiale par rapport à l'axe z entre ledit au moins un système de bobines ou de résonateur et le système de gradients, l'agencement d'écran se présentant sous la forme d'une enveloppe cylindrique et comportant au moins une couche électroconductrice avec au moins une fente (1, 7, 8), la couche électroconductrice étant disposée de manière axisymétrique par rapport à l'axe z autour du point médian de l'agencement d'écran, et ladite au moins une fente (1, 7, 8) sectionnant en totalité et subdivisant en parties ou segments (3), ladite au moins une couche électroconductrice dans une direction présentant une composante z différente de 0,
> - l'agencement d'écran, dans un segment axial z1<z<z2, avec z2-z1>L, avec L = la longueur de la fenêtre du système de bobines ou de résonateur contenant au moins 90 % de l'énergie de champ magnétique du système de bobines ou de résonateur, présentant au moins un couple de zones se présentant sous la forme d'enveloppes cylindriques (6) autour de l'axe ou de la direction z, les deux zones (6) de chacun des couples étant respectivement définies par deux limites fermées sur elles-mêmes et tournant autour de l'axe ou de la direction z et les deux limites de chaque zone (6) étant situées à une certaine distance axiale $a \leq \dfrac{z2-z1}{2}$ l'une de l'autre et se trouvant sur les plans parallèles au plan xy, c'est-à-dire de manière perpendiculaire par rapport à l'axe ou à la direction z,

> **caractérisé en ce que**

> > - les deux zones (6) d'un couple de ce type, du fait de la géométrie de l'agencement d'écran pour au moins un mode caractéristique de l'agencement d'écran, présentent des couplages d'induction opposés audit au moins un système de bobines ou de résonateur,
> > - ladite au moins une fente (1, 7, 8) étant disposée de telle manière que chacun(e) des parties ou segments (3) tourne dans la longueur de la fenêtre L dudit au moins un système de bobines ou de résonateur au moins une fois entièrement autour de l'axe z.

2. Appareil de résonance magnétique nucléaire selon la revendication 1, **caractérisé en ce que**, dans le cadre d'au moins une fente (1) de la couche électroconductrice de l'agencement d'écran, le gradient par rapport à l'axe ou direction z est uniforme sur tout le segment z1<z<z2 de l'agencement d'écran.

3. Appareil de résonance magnétique nucléaire selon l'une quelconque des revendications précédentes, **caractérisé en ce qu'**au moins une fente (1) de la couche électroconductrice de l'agencement d'écran présente un multiple entier de rotations autour de l'axe ou direction z sur la longueur de fenêtre L d'un ou de tous les systèmes de bobines ou de résonateur HF.

4. Appareil de résonance magnétique nucléaire selon l'une quelconque des revendications précédentes, **caractérisé en ce que**, en plus de la fente (1) au moins au nombre de une sectionnant entièrement la couche électroconductrice de l'agencement d'écran, au moins une autre fente (5) est prévue, laquelle ne sectionne pas entièrement la couche électroconductrice en commençant au niveau d'une arrête terminale de l'agencement d'écran.

5. Appareil de résonance magnétique nucléaire selon la revendication 4, **caractérisé en ce qu'**au moins une des autres fentes (5) s'étend exclusivement à l'extérieur de la longueur de fenêtre L du système de bobines ou de résonateur au moins au nombre de un.

6. Appareil de résonance magnétique nucléaire selon la revendication 4, **caractérisé en ce que** les autres fentes (5) tournent sur la longueur de la fenêtre L du système de bobines ou de résonateur au moins au nombre de un au moins une fois entièrement autour de l'axe ou direction z.

**7.** Appareil de résonance magnétique nucléaire selon l'une quelconque des revendications précédentes, **caractérisé en ce que** les fentes (1, 5) présentent, en dehors de la longueur de la fenêtre L du système de bobines ou de résonateur HF au moins au nombre de un, un gradient plus faible ou un gradient supérieur par rapport à l'axe ou direction z que sur ou dans la longueur de fenêtre L.

**8.** Appareil de résonance magnétique nucléaire permettant de produire un champ magnétique statique homogène selon un axe ou une direction z avec

- au moins un système de bobines ou de résonateur servant à émettre et/ou à recevoir des signaux haute fréquence (HF) sur au moins une fréquence de mesure,
- un système de gradients servant à produire des gradients de champ à impulsions dans au moins une direction de l'espace et
- un agencement d'écran positionné de manière radiale par rapport à l'axe z entre le système de bobines ou de résonateur au moins au nombre de un et le système de gradients, l'agencement d'écran se présentant sous la forme d'une enveloppe cylindrique et comportant au moins une couche électroconductrice avec au moins une fente (1, 7, 8), la couche électroconductrice étant disposée de manière axisymétrique par rapport à l'axe z autour du point médian de l'agencement d'écran et la fente (1, 7, 8) au moins au nombre de une sectionnant en totalité la couche électroconductrice au moins au nombre de une et la subdivisant en parties ou segments (3),
- l'agencement d'écran, dans un segment axial z1<z<z2, avec z2-z1>L, avec L = la longueur de la fenêtre du système de bobines ou de résonateur contenant au moins 90 % de l'énergie de champ magnétique du système de bobines ou de résonateur, présentant au moins un couple de zones se présentant sous la forme d'une enveloppe cylindrique (6) autour de l'axe ou de la direction z, les deux zones (6) de chacun des couples étant respectivement définies par deux limites fermées sur elles-mêmes et tournant autour de l'axe ou de la direction z, et les deux limites de chaque zone (6) étant situées à une certaine distance axiale $a \leq \dfrac{z2 - z1}{2}$ l'une de l'autre et se trouvant sur les plans parallèles au plan xy, c'est-à-dire de manière perpendiculaire par rapport à l'axe ou direction z,

**caractérisé en ce que**

- les deux zones (6) d'un couple de ce type, du fait de la géométrie de l'agencement d'écran pour au moins un mode caractéristique de l'agencement d'écran, présentent des couplages d'induction opposés audit au moins un système de bobines ou de résonateur,
- ladite au moins une fente (7) de la couche électroconductrice de l'agencement d'écran s'étendant en continu de manière parallèle par rapport au plan xy, l'agencement de ladite au moins une fente (7) s'étendant de manière parallèle par rapport au plan xy étant symétrique par rapport au plan xy et, au moins un couple de fentes axiales (8) étant en plus prévu au moins dans une zone centrale de la longueur de fenêtre L, les fentes axiales (8) étant orientées de manière parallèle par rapport à l'axe z et reliant respectivement deux fentes (7) voisines s'étendant de manière parallèle par rapport au plan xy ou une fente (7) s'étendant de manière parallèle par rapport au plan xy et une arrête terminale (9) de la couche électroconductrice de l'agencement d'écran, tout l'agencement des fentes (7,8) présentant une symétrie ponctuelle par rapport au point médian de l'agencement d'écran, mais ne présentant aucune symétrie plane par rapport au plan xy qui passe par le centre du système de bobines ou de résonateur.

**9.** Appareil de résonance magnétique nucléaire selon la revendication 8, **caractérisé en ce qu'**il existe une zone (13) de l'agencement d'écran au milieu de la longueur de fenêtre L, qui ne présente aucune fente.

**10.** Appareil de résonance magnétique nucléaire selon la revendication 8, **caractérisé en ce que** toutes les zones (6) de l'agencement d'écran selon l'axe ou la direction z présentent respectivement une fente axiale (8).

**11.** Appareil de résonance magnétique nucléaire selon l'une quelconque des revendications 8 à 10, **caractérisé en ce que** les distances des fentes voisines (7) s'étendant de manière parallèle par rapport au plan xy sont respectivement identiques.

**12.** Appareil de résonance magnétique nucléaire selon l'une quelconque des revendications 8 à 10, **caractérisé en ce que** les distances des fentes voisines (7) s'étendant de manière parallèle par rapport au plan xy sont plus faibles dans la zone du centre de la longueur de fenêtre L qu'à l'extérieur de la longueur de fenêtre L.

**13.** Appareil de résonance magnétique nucléaire selon l'une quelconque des revendications précédentes, **caractérisé en ce que** l'agencement d'écran soit présente exactement une couche électroconductrice ainsi que des éléments capacitifs (14, 15) insérés ou montés par ladite au moins une fente (1, 7, 8) de telle sorte que les courants HF peuvent très facilement et très librement circuler dans la zone de la fréquence de mesure, soit comporte deux couches électroconductrices, entre lesquelles est disposée une couche diélectrique non conductrice, les fentes (1, 7, 8) ne s'étendant pas de manière égale dans les deux couches électroconductrices.

ν$_{NMR}$/MHz; B=18.79T

Fig.1a

ν$_{NMR}$/MHz; B=18.79T

Fig. 1b

ν$_{NMR}$/MHz; B=11.74, 14.09, 16.44, 18.79T

Fig.1c

Fig.2

1 ·2π        1 ·4π        1 ·8π

Fig. 3a

2 ·2π        2 ·4π        2 ·6π

Fig. 3b

4 ·2π    4 ·4π    8 ·2π

Fig. 3c

2a    2b

$L_1$    $L_2$

1    $L_1$: 8π  $L_2$: 6π

Fig. 4

$L_1$    $L_2$

$L_1$: 4π  $L_2$: 2π

Fig. 5

Fig. 6a

Fig. 6b

Fig. 7a

Fig. 7b

Fig. 8a

Fig. 8b

Fig. 9

Fig. 10a

Fig. 10b

Fig. 11a

Fig. 11b

Fig. 12a

Fig. 12b

Fig. 13

Fig. 14

Fig. 15a

Fig. 15b

Fig. 15c

L

13

**Fig. 16**

z

$\Phi_\perp$

**Fig. 17a**

6

6

**Fig. 17b**

3   14   3

16

3   3

15

**Fig. 18a**        **Fig. 18b**        **Fig. 18c**        **Fig. 18d**

Fig. 19a

Fig. 19b

Fig. 19c

Fig. 20a

Fig. 20b

Fig. 21

**EP 1 746 432 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4310799 A1
- US 4506224 A1
- US 4642569 A1
- US 4871969 A1
- US 4879515 A1
- US 5243286 A1
- US 5381093 A1
- US 5572129 A1
- US 5574372 A1
- US 5680046 A1
- US 6420871 B1
- US 2004189304 A1
- WO 0178089 A1